# EUROPÄISCHE PATENTSCHRIFT

(11) **EP 2 168 181 B1**
(45) Veröffentlichungstag und Bekanntmachung des Hinweises auf die Patenterteilung: **12.05.2021**
(21) Anmeldenummer: 08785954.2
(22) Anmeldetag: 07.07.2008
(51) Int. Cl.: H01L 51/42, H01L 51/46

(54) **MISCHUNGEN ZUR HERSTELLUNG VON PHOTOAKTIVEN SCHICHTEN FÜR ORGANISCHE SOLARZELLEN UND ORGANISCHE PHOTODETEKTOREN**
MIXTURES FOR PRODUCING PHOTOACTIVE LAYERS FOR ORGANIC SOLAR CELLS AND ORGANIC PHOTODETECTORS
MÉLANGES POUR LA FABRICATION DE COUCHES PHOTOACTIVES POUR DES PILES SOLAIRES ORGANIQUES ET DES PHOTODÉTECTEURS ORGANIQUES

(30) Priorität: 10.07.2007 EP 07112153
(43) Veröffentlichungstag der Anmeldung: 31.03.2010
(73) Patentinhaber: Heliatek GmbH, 01139 Dresden (DE)
(72) Erfinder: KLAUS, Meerholz, 51503 Rösrath (DE); WÜRTHNER, Frank, 97204 Höchberg (DE)
(86) Internationale Anmeldenummer: PCT/EP2008/058773
(87) Internationale Veröffentlichungsnummer: WO 2009/007340

(56) Entgegenhaltungen:
- EP-A- 0 901 175
- WO-A-03/077323
- WO-A-2006/092135
- DE-A1- 19 621 026
- YAMANARI T ET AL: "Dye-sensitized bulk heterojunction polymer solar cells" CONFERENCE RECORD OF THE 2006 IEEE 4TH WORLD CONFERENCE ON PHOTOVOLTAIC ENERGY CONVERSION (IEEE CAT. NO. 06CH37747) IEEE PISCATAWAY, NJ, USA, 2006, Seite 4 pp., XP002500718 ISBN: 1-4244-0016-3
- MENG F ET AL: "SYNTHESIS OF NOVEL CYANINE-FULLERENCE DYADS FOR PHOTOVOLTAIC DEVICES" JOURNAL OF MATERIALS CHEMISTRY, THE ROYAL SOCIETY OF CHEMISTRY, CAMBRIDGE, GB, Bd. 15, Nr. 9, 7. März 2005 (2005-03-07), Seiten 979-986, XP008072202 ISSN: 0959-9428
- ZHU D ET AL: "DESIGN, SYNTHESIS AND PROPERTIES OF FUNCTIONAL MATERIALS BASED ON FULLERENE" SYNTHETIC METALS, ELSEVIER SEQUOIA, LAUSANNE, CH, Bd. 133-134, 13. März 2003 (2003-03-13), Seiten 679-683, XP008072186 ISSN: 0379-6779
- MENG FANSHUN ET AL: "Cyanine dye acting both as donor and acceptor in heterojunction photovoltaic devices" APPLIED PHYSICS LETTERS, AIP, AMERICAN INSTITUTE OF PHYSICS, MELVILLE, NY, Bd. 82, Nr. 21, 26. Mai 2003 (2003-05-26), Seiten 3788-3790, XP012034231 ISSN: 0003-6951
- SAITO K: "SENSITIZATION OF THE PHOTOCURRENT IN C60/MEROCYANINE J-AGGREGATE HETEROJUNCTION PHOTOVOLTAIC CELLS" JAPANESE JOURNAL OF APPLIED PHYSICS, JAPAN SOCIETY OF APPLIED PHYSICS, TOKYO.; JP, Bd. 38, Nr. 10A, 1. Oktober 1999 (1999-10-01), Seiten L1140-L1142, XP008072182 ISSN: 0021-4922

## Beschreibung

Die vorliegende Erfindung betrifft die Verwendung von Mischungen, welche Verbindungen D-A enthalten, in welchen D für eine Donor- und A für eine Akzeptorgruppierung steht, insbesondere die Verwendung von Mischungen, welche Verbindungen D-A und Fulleren-Derivate enthalten, zur Herstellung von photoaktiven Schichten für organische Solarzellen und organische Photodetektoren, entsprechende organische Solarzellen und organische Photodetektoren, sowie Mischungen, welche Verbindungen D-A und Fulleren-Derivate enthalten.

Es wird erwartet, dass zukünftig in vielen Bereichen der Elektronikindustrie neben den klassischen anorganischen Halbleitern zunehmend auch organische Halbleiter auf Basis von niedermolekularen oder polymeren Materialien eingesetzt werden. Diese weisen vielfach Vorteile gegenüber den klassischen anorganischen Halbleitern auf, beispielsweise eine bessere Substratkompatibilität und eine bessere Verarbeitbarkeit der auf ihnen basierenden Halbleiterbauteile. Sie erlauben die Verarbeitung auf flexiblen Substraten und ermöglichen es, ihre Grenzorbitalenergien mit den Methoden des Molecular Modellings auf den jeweiligen Anwendungsbereich genau anzupassen. Die deutlich verringerten Kosten derartiger Bauteile haben dem Forschungsgebiet der organischen Elektronik eine Renaissance gebracht. Die "Organische Elektronik" beschäftigt sich schwerpunktmäßig mit der Entwicklung neuer Materialien und Fertigungsprozesse für die Herstellung elektronischer Bauelemente auf der Basis organischer Halbleiterschichten. Dazu zählen vor allem organische Feldeffekttransistoren (Organic Field-Effect Transistors, OFET) sowie organische Leuchtdioden (Organic Light Emitting Diodes, OLED; z.B. für den Einsatz in Displays) und die organische Photovoltaik.

Die Direktumwandlung von Solarenergie in elektrische Energie in Solarzellen beruht auf dem inneren Photoeffekt eines Halbleitermaterials, d.h. der Erzeugung von Elektron-Loch-Paaren durch Absorption von Photonen und der Trennung der negativen und positiven Ladungsträger an einem p-n-Übergang oder einem Schottky-Kontakt. Die so erzeugte Photospannung kann in einem äußeren Stromkreis einen Photostrom bewirken, durch den die Solarzelle ihre Leistung abgibt.

Vom Halbleiter können dabei nur solche Photonen absorbiert werden, die eine Energie aufweisen, die größer als seine Bandlücke ist. Die Größe der Halbleiterbandlücke bestimmt also den Anteil des Sonnenlichts, der in elektrische Energie umgewandelt werden kann. Es wird zukünftig erwartet, dass organische Solarzellen die klassischen Solarzellen auf Siliziumbasis aufgrund geringerer Kosten, eines geringeren Gewichts, der Möglichkeit zur Herstellung flexibler und/oder farbiger Zellen, der besseren Möglichkeit zur Feinabstimmung des Bandabstands übertreffen werden. Es besteht somit ein großer Bedarf an organischen Halbleitern, die sich zur Herstellung organischer Solarzellen eignen.

Um die Sonnenenergie möglichst effektiv zu nutzen bestehen organische Solarzellen normalerweise aus zwei absorbierenden Materialien mit unterschiedlicher Elektronenaffinität bzw. unterschiedlichem Ionisationsverhalten. Das eine Material wirkt dann als p-Leiter (Elektronendonor), das andere als n-Leiter (Elektronenakzeptor). Die ersten organischen Solarzellen bestanden aus einem zweilagigen System aus einem KupferPhthalocyanin als p-Leiter und PTCBI als n-Leiter und zeigten einen Wirkungsgrad von 1%. Um möglichst alle auftreffenden Photonen zu nutzen, werden relativ hohe Schichtdicken eingesetzt (z.B. 100 nm). Um Strom zu erzeugen, muss der durch die absorbierten Photonen erzeugte angeregte Zustand jedoch eine p-n-Grenzschicht ("p-n-junction") erreichen, um ein Loch und ein Elektron zu erzeugen, welches dann zur Anode und Kathode fließt. Die meisten organischen Halbleiter haben jedoch nur Diffusionslängen für den angeregten Zustand von bis zu 10 nm. Selbst durch die besten bisher bekannten Herstellverfahren kann die Distanz, über die der angeregte Zustand weitergeleitet werden muss, auf minimal 10 bis 30 nm verringert werden.

Neuere Entwicklungen in der organischen Photovoltaik gehen in die Richtung der sogenannten "Bulk-Heterojunction": die photoaktive Schicht enthält hierbei die Akzeptor- und Donorverbindung(en) als bikontinuierliche Phase. Durch photoinduzierten Ladungstransfer vom angeregten Zustand der Donorverbindung zur Akzeptorverbindung findet aufgrund der räumlichen Nähe der Verbindungen eine, verglichen mit anderen Relaxationsvorgängen, schnelle Ladungstrennung statt und die entstandenen Löcher und Elektronen werden über die entsprechende Elektroden abgeführt. Zwischen die Elektroden und die photoaktive Schicht werden oftmals weitere Schichten, wie z.B. Löcher- oder Elektronentransportschichten, aufgebracht, um die Effizienz solcher Zellen zu erhöhen.

Bislang werden als Donormaterialien in solchen Bulk-Heterojunction-Zellen meist Polymere, wie z.B. Polyvinylphenylene oder Polythiophene, oder Farbstoffe aus der Klasse der Phthalocyanine, z.B. Zn- oder Vanadylphthalocyanin, und als Akzeptormaterialien Fulleren und Fulleren-Derivate sowie verschiedene Perylene verwendet. Intensiv wurden und werden photoaktive Schichten aus den Donor-/Akzeptor-Paaren Poly(3-hexyl-thiophen) ("P3HT")/ [6,6]-Phenyl-C₆₁-butylsäuremethylester ("PCBM"), Poly(2-methoxy-5-(3,7-dimethyloctyloxy)-1,4-phenylenvinylen)("OC₁C₁₀-PPV")/PCBM und Zn-Phthalocyanin/Fulleren untersucht.

Yamanari T. et al. ("Dye-sensitized Bulk Heterojunction Polymer Solar Cells", Conference Record of the 2006 IEEE 4th World Conference on Photovoltaic Energy Conversion (IEEE CAT. NO. 06CH37747) IEEE PISCATAWAY, NJ, USA, 2006, Seite 4 pp., XP002500718) offenbart organische Solarzellen basierend auf Poly(3-Hexylthiophene) (P3HT) und [6,6]-Phenyl-C61-Buttersäuremethylester (PCBM).

EP 0 901 175 A2 offenbart eine photoelektrische Umwandlungsvorrichtung mit einer Schicht aus farbstoffsensibilisiertem nanopartikulärem Halbleiter und einer Lochtransportschicht, die ein organisches Lochtransportmittel enthält.

WO 2006/092135 A1 offenbart ein photoaktives Bauelement mit organischen Schichten, insbesondere eine Solarzelle, mit einer Schichtanordnung, welche eine Elektrode und eine Gegenelektrode sowie eine Folge organischer Schichten aufweist, die zwischen der Elektrode und der Gegenelektrode angeordnet ist.

Aufgabe der vorliegenden Erfindung war es nun, weitere photoaktive Schichten zur Verwendung in elektronischen Bauelementen, insbesondere in organischen Solarzellen und organischen Photodetektoren, bereitzustellen, welche leicht herstellbar sind

und für die Umwandlung von Lichtenergie in elektrische Energie in technischen Anwendungen einen ausreichenden Wirkungsgrad aufweisen.

Dementsprechend wurden die Verwendung von Mischungen, welche als Komponenten enthalten
K1) ein oder mehrere Verbindungen der allgemeinen Formel k1

   D-A (k1)

   als Elektronendonor bzw. Elektronenakzeptor, worin bedeuten
D eine Donorgruppierung, welche mindestens eine Kohlenstoff-Kohlenstoff- oder Kohlenstoff-Heteroatom-Doppelbindung und mindestens einen, gegebenenfalls anellierten carbo- oder heterocyclischen Ring enthält,
A eine Akzeptorgruppierung, welche mindestens eine Kohlenstoff-Kohlenstoff- oder Kohlenstoff-Heteroatom-Doppelbindung und mindestens einen, gegebenenfalls anellierten carbo- oder heterocyclischen Ringe enthält, ausgewählt aus der Gruppe bestehend aus: 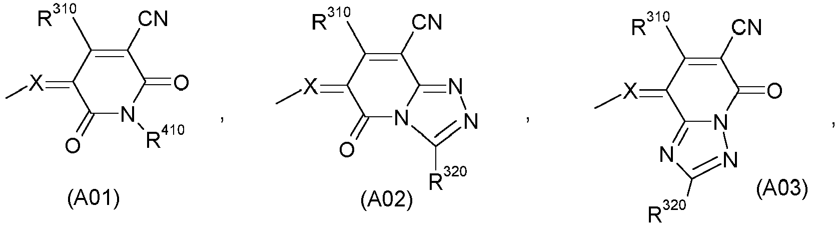 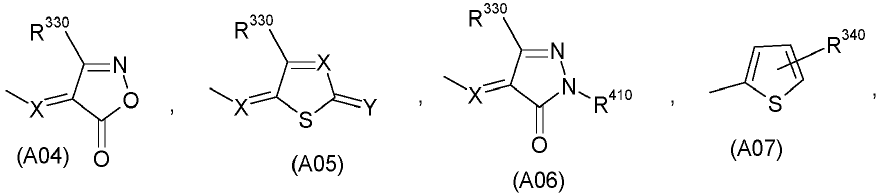 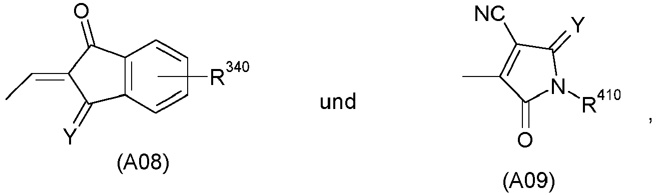 worin bedeuten
   - R³¹⁰ und R³²⁰: unabhängig voneinander Wasserstoff, C₁-C₁₀-Alkyl, das durch ein oder zwei nicht benachbarte Sauerstoffatome unterbrochen sein kann, oder C₅-C₇-Cycloalkyl,
   - R³³⁰: Wasserstoff, C₁-C₁₀-Alkyl, das durch ein oder zwei nicht benachbarte Sauerstoffatome unterbrochen sein kann, teilweise fluoriertes C₁-C₁₀-Alkyl, perfluoriertes C₁-C₁₀-Alkyl, C₅-C₇-Cycloalkyl oder Aryl,
   - R³⁴⁰: Wasserstoff, NO₂, CN, COR³⁵⁰, COOR³⁵⁰, SO₂R³⁵⁰ oder SO₃R³⁵⁰, worin R³⁵⁰ die Bedeutung von Aryl oder C₁-C₁₀-Alkyl besitzt,
   - R⁴¹⁰: C₁-C₁₀-Alkyl, das durch ein oder zwei nicht benachbarte Sauerstoffatome unterbrochen sein kann, C₅-C₇-Cycloalkyl, Aryl, Aryl-C₁-C₁₀-alkyl, Aryloxy-C₁-C₁₀-Alkyl, einen Rest-NHCOR⁴²⁰ oder einen Rest-N(CO R⁴²⁰)₂, worin R⁴²⁰ die Bedeutung von Aryl, Aryl-C₁-C₁₀-alkyl oder C₁-C₁₀-Alkyl, das durch ein oder zwei nicht benachbarte Sauerstoffatome unterbrochen sein kann, besitzt, und die beiden R⁴²⁰ im Rest-N(CO R⁴²⁰)₂ gleich oder voneinander verschieden sein können,
   - X: unabhängig voneinander CH oder N
   und
   - Y: O, C(CN)₂ oder C(CN)(COOR⁴³⁰), worin R⁴³⁰ die Bedeutung C₁-C₁₀-Alkyl, das durch ein oder zwei nicht benachbarte Sauerstoffatome unterbrochen sein kann, besitzt,
   und die Donorgruppierung D und die Akzeptorgruppierung A miteinander in π-Konjugation stehen,
   und
K2) ein oder mehrere Verbindungen, welche gegenüber Komponente K1) entsprechend als Elektronenakzeptor bzw. Elektronendonor wirken,
   zur Herstellung von photoaktiven Schichten für organische Solarzellen und organische Photodetektoren gefunden.

Insbesondere ist die Donorgruppierung D in den ein oder mehreren Verbindungen der allgemeinen Formel k1 ausgewählt aus der Gruppe bestehend aus: 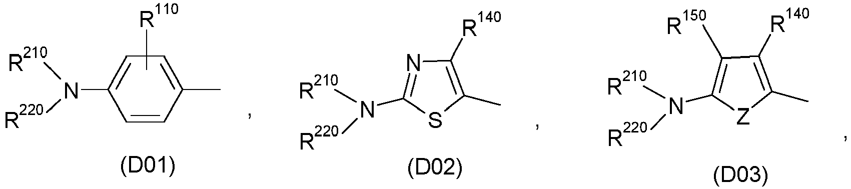 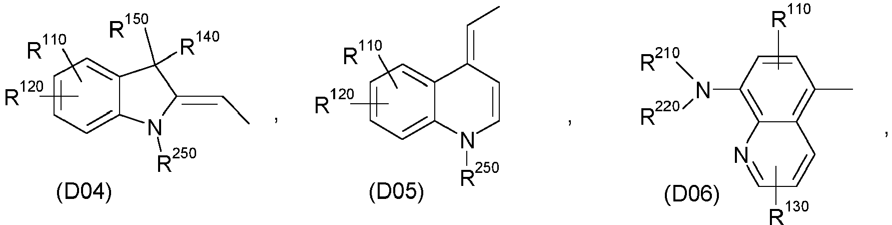 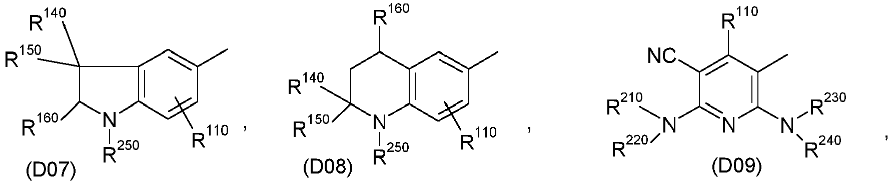 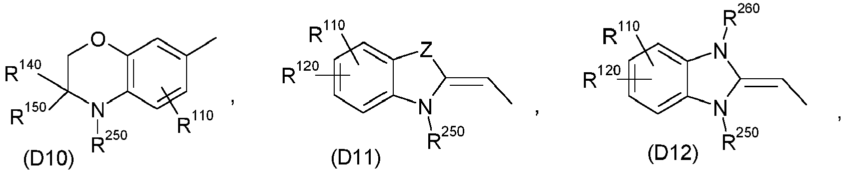 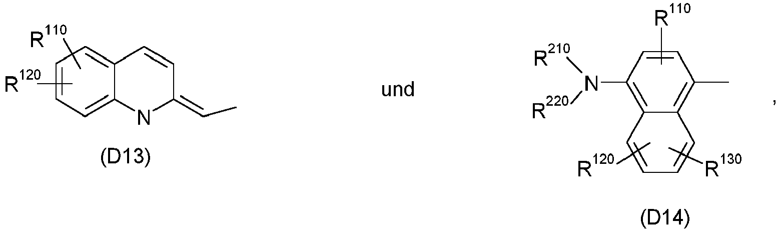 worin bedeuten
- R¹¹⁰, R¹²⁰ und R¹³⁰: unabhängig voneinander Wasserstoff, Halogen, Hydroxy, C₁-C₁₀-Alkyl, das durch ein oder zwei nicht benachbarte Sauerstoffatome unterbrochen sein kann, C₅-C₇-Cycloalkyl, C₁-C₁₀-Alkoxy, C₁-C₁₀-Alkylamino, Di(C₁-C₁₀-alkyl)amino, C₁-C₁₀-Alkylamino- oder Di(C₁-C₁₀-alkyl)aminosulfonyl-amino, C₁-C₁₀-Alkylsulfonylamino, Aryl, Aryl-C₁-C₁₀-alkyl, Aryloxy-C₁-C₁₀-alkyl oder einen Rest-NHCOR¹⁷⁰ oder-NHCOOR¹⁷⁰, worin R¹⁷⁰ die Bedeutung von Aryl, Aryl-C₁-C₁₀-alkyl oder C₁-C₁₀-Alkyl, das durch ein oder zwei nicht benachbarte Sauerstoffatome unterbrochen sein kann, besitzt,
- R¹⁴⁰, R¹⁵⁰ und R¹⁶⁰: unabhängig voneinander Wasserstoff, C₁-C₁₀-Alkyl, das durch ein oder zwei nicht benachbarte Sauerstoffatome unterbrochen sein kann, C₅-C₇-Cycloalkyl oder Aryl,
- R²¹⁰, R²²⁰, R²³⁰ und R²⁴⁰: unabhängig voneinander C₁-C₁₀-Alkyl, das durch ein oder zwei nicht benachbarte Sauerstoffatome unterbrochen sein kann, oder C₅-C₇-Cycloalkyl, oder R²¹⁰ und R²²⁰ und/oder R²³⁰ und R²⁴⁰ bilden zusammen mit dem Stickstoffatom, an welches sie gebunden sind, einen fünf- oder sechsgliedrigen Ring, in welchem eine der zum Stickstoffatom nicht benachbarten CH₂-Gruppen durch ein Sauerstoffatom ersetzt sein kann,
- R²⁵⁰ und R²⁶⁰: unabhängig voneinander C₁-C₁₀-Alkyl, das durch ein oder zwei nicht benachbarte Sauerstoffatome unterbrochen sein kann, C₅-C₇-Cycloalkyl, Aryl, Aryl-C₁-C₁₀-alkyl oder Aryloxy-C₁-C₁₀-alkyl
und
- Z: O oder S.

Die Definitionen der vorstehend aufgeführten Variablen werden nachfolgend erläutert und sind wie nachfolgend zu verstehen.

Halogen bezeichnet Fluor, Chlor, Brom und lod, insbesondere Fluor und Chlor.

Unter C₁-C₁₀-Alkyl ist lineares oder verzweigtes Alkyl, beispielsweise Methyl, Ethyl, n-Propyl, Isopropyl, n-Butyl, Isobutyl, sec.-Butyl, tert.-Butyl, n-Pentyl, n-Hexyl, n-Heptyl, n-Octyl, 2-Ethylhexyl, n-Nonyl und n-Decyl zu verstehen. Bevorzugte Gruppen sind Methyl, Isopropyl, n-Butyl, tert.-Butyl und 2-Ethylhexyl; in den genannten Resten können gegebenenfalls ein oder mehrere Wasserstoffatome durch Fluoratome ersetzt sein, so dass diese Reste auch teilfluoriert oder perfluoriert sein können.

Unter C₁-C₁₀-Alkyl, welches durch ein oder zwei nicht benachbarte Sauerstoffatome unterbrochen ist, ist beispielsweise 3-Methoxyethyl, 2- und 3-Methoxy-propyl, 2-Ethoxyethyl, 2- und 3-Ethoxypropyl, 2-Propoxyethyl, 2- und 3-Propoxypropyl, 2-Butoxyethyl, 2- und 3-Butoxypropyl, 3,6-Dioxaheptoyl und 3,6-Dioxaoctyl zu nennen.

Die C₁-C₁₀-Alkoxy-, C₁-C₁₀-Alkylamino-, Di(C₁-C₁₀-alkyl)amino-, C₁-C₁₀-Alkylamino-sulfonylamino-, Di(C₁-C₁₀-alkyl)aminosulfonylamino- und C₁-C₁₀-Alkylsulfonylamino-Reste leiten sich entsprechend von den zuvor genannten C₁-C₁₀-Alkylresten ab, wobei sich im Falle der Di(C₁-C₁₀-alkyl)amino-Gruppen sowohl gleiche als auch unterschiedliche C₁-C₁₀-Alkyl-Reste an der Amino-Gruppe befinden können. Beispielsweise sind zu nennen Methoxy, Ethoxy, n-Propoxy, Isopropoxy, n-Butoxy, Isobutoxy, sec.-Butoxy, tert.-Butoxy, n-Pentoxy, n-Hexoxy, n-Heptoxy, n-Octoxy, 2-Ethylhexoxy, n-Nonoxy und n-Decoxy, Methylamino, Ethylamino, n-Propylamino, Isopropylamino, n-Butylamino, Isobutylamino, sec.-Butylamino, tert.-Butylamino, n-Pentylamino, n-Hexylamino, n-Heptylamino, n-Octylamino, 2-Ethylhexylamino, n-Nonylamino und n-Decylamino, Dimethylamino, Diethylamino, Di(n-propyl)amino, Diisopropylamino, Di(n-butyl)amino, Diisobutylamino, Di(sec.-butyl)amino, Di(tert.-butyl)amino, Di(n-pentyl)amino, Di(n-hexyl)amino, Di(n-heptyl)amino, Di(n-octyl)amino, Di(2-ethylhexyl)amino, Di(n-nonyl)-amino und Di(n-decyl)amino sowie die entsprechenden gemischten Dialkylamino-Reste, wie etwa Methylethylamino bis Methyl-n-decylamino, Ethyl-n-propylamino bis Ethyl-n-decylamino usw., desweiteren Methylaminosulfonylamino, Ethylaminosulfonylamino, n-Propyl-aminosulfonylamino, Isopropylaminosulfonylamino, n-Butylaminosulfonylamino, Isobutylaminosulfonylamino, sec.-Butylaminosulfonylamino, tert.-Butylaminosulfonylamino, n-Pentylaminosulfonylamino, n-Hexylaminosulfonylamino, n-Heptylaminosulfonylamino, n-Octylaminosulfonylamino, 2-Ethylhexylaminosulfonylamino, n-Nonylaminosulfonylamino und n-Decylaminosulfonylamino, Dimethylaminosulfonylamino, Diethylaminosulfonylamino, Di(n-propyl)aminosulfonylamino, Diisopropylaminosulfonylamino, Di(n-butyl)aminosulfonylamino, Diisobutylaminosulfonylamino, Di(sec.-butyl)amino-sulfonylamino, Di(tert.-butyl)aminosulfonylamino, Di(n-pentyl)-aminosulfonylamino, Di(n-hexyl)aminosulfonylamino, Di(n-heptyl)aminosulfonylamino, Di(n-octyl)aminosulfonylamino, Di(2-ethylhexyl)aminosulfonylamino, Di(n-nonyl)aminosulfonylamino und Di(n-decyl)aminosulfonylamino sowie die entsprechenden, gemischte Dialkylamino-Reste enthaltenden Reste, wie etwa Methylethylaminosulfonylamino bis Methyl-n-decyl-aminosulfonylamino, Ethyl-n-propylaminosulfonylamino bis Ethyl-n-decylaminosulfonylamino usw. bis zu n-Nonyl-n-decylaminosulfonylamino sowie Methylsulfonylamino, Ethylsulfonylamino, n-Propylsulfonylamino, Isopropylsulfonylamino, n-Butylsulfonylamino, Isobutylsulfonylamino, sec.-Butylsulfonylamino, tert.-Butylsulfonylamino, n-Pentylsulfonylamino, n-Hexylsulfonylamino, n-Heptylsulfonylamino, n-Octylsulfonylamino, 2-Ethylhexylsulfonylamino, n-Nonylsulfonylamino und n-Decylsulfonylamino.

Unter C₅-C₇-Cylcloalkyl sind insbesondere Cylcopentyl, Cyclohexyl und Cycloheptyl zu verstehen.

Aryl umfasst ein- oder mehrkernige aromatische Kohlenwasserstoffreste, die unsubstituiert oder substituiert sein können. Aryl steht vorzugsweise für Phenyl, Tolyl, Xylyl, Mesityl, Duryl, Naphthyl, Fluorenyl, Anthracenyl, Phenanthrenyl oder Naphthyl, besonders bevorzugt für Phenyl oder Naphthyl, wobei diese Arylgruppen im Falle einer Substitution im Allgemeinen 1, 2, 3, 4 oder 5, vorzugsweise 1, 2 oder 3 Substituenten tragen können, die ausgewählt sind aus der Gruppe der Reste bestehend aus C₁-C₁₀-Alkyl, C₁-C₁₀-Alkoxy, Cyano, Nitro, SO₂NR^{a}R^{b}, NHSO₂NR^{a}R^{b}, CONR^{a}R^{b} und CO₂R^{a}, wobei sich die C₁-C₁₀-Alkoxygruppen von den zuvor aufgeführten C₁-C₁₀-Alkylgruppen ableiten. R^{a} und R^{b} stehen vorzugsweise unabhängig voneinander für Wasserstoff oder C₁-C₁₀-Alkyl.

Die Aryl-C₁-C₁₀-alkyl- und Aryloxy-C₁-C₁₀-Alkylgruppen leiten sich von den zuvor aufgeführten Alkyl- und Arylgruppen durch formalen Ersatz eines Wasserstoffatoms der linearen oder verzweigten Alkylkette durch eine Aryl- oder Aryloxygruppe ab. Bevorzugte Gruppen sind hier Benzyl und lineares Aryloxy-C₁-C₁₀-alkyl, wobei im Falle von C₂-C₁₀-Alkylresten der Aryloxyrest vorzugsweise terminal gebunden ist.

In den photoaktiven Schichten kann die Komponente K1 die Rolle des Elektronendonors übernehmen, entsprechend kommt dann der Komponente K2 die Rolle des Elektronenakzeptors zu. Alternativ kann aber auch die die Komponente K1 die Rolle des Elektronenakzeptors annehmen, entsprechend fungiert dann Komponente K2 als Elektronendonor. In welcher Weise die jeweilige Komponente wirkt hängt von der Energie des HOMO bzw. LUMO der Komponente K1 im Verhältnis zur Energie des HOMO bzw. LUMO der Komponente K2 ab. Bei den Verbindungen der Komponente K1, insbesondere bei den Verbindungen mit den zuvor aufgeführten, bevorzugten Donorgruppierungen D01 bis D14 und Akzeptorgruppierungen A01 bis A09, handelt es sich typischerweise um Merocyanine, welche üblicherweise als Elektronendonoren in Erscheinung treten. Insbesondere ist dies der Fall, wenn als Komponente K2 Rylen- oder Fulleren-Derivate Verwendung finden, welche dann in der Regel als Elektronenakzeptoren wirken. Diese Rollen können sich im konkreten Einzelfall jedoch vertauschen. Anzumerken ist auch, dass Komponente K2 ebenfalls der strukturellen Definition der Komponente K1 gehorchen kann, so dass eine Verbindung der Formel D-A die Rolle des Elektronendonors und eine andere Verbindung der Formel D-A die Rolle des Elektronenakzeptors übernehmen kann.

Vorzugsweise finden Mischungen erfindungsgemäße Verwendung, in welchen die Verbindungen der allgemeinen Formel k1 oder die bevorzugten Verbindungen, in welchen den Donorgruppierungen D und/oder den Akzeptorverbindungen A die zuvor aufgeführte Bedeutung der Gruppierungen D01 bis D14 bzw. A01 bis 09 zukommt, jeweils eine Molekülmasse von maximal 1.000 g/mol, insbesondere maximal 600 g/mol besitzen.

Weiter finden insbesondere Verwendung solche Mischungen, unter Berücksichtigung der zuvor aufgeführten Bevorzugungen, in welchen es sich bei Komponente K2 um ein oder mehrere Fullerene und/oder Fulleren-Derivate handelt.

Als mögliche Fullerene sind zu nennen C₆₀, C₇₀, C₇₆, C₈₀, C₈₂, C₈₄, C₈₆, C₉₀ und C₉₄, insbesondere das C₆₀ und C₇₀. Einen Überblick über Fullerene, welche erfindungsgemäß verwendet werden können, liefert beispielsweise die Monografie von A. Hirsch, M. Brettreich, "Fullerenes: Chemistry and Reactions", Wiley-VCH, Weinheim 2005.

Die Fulleren-Derivate erhält man üblicherweise durch Reaktion an einer oder mehreren der in den Fullerenen enthaltenen Kohlenstoff-Kohlenstoff-Doppelbindungen, wobei der Charakter der Fulleren-Einheit in den resultierenden Derivaten im Wesentlichen nicht verändert wird.

Unter Berücksichtigung der zuvor aufgeführten Bevorzugungen finden insbesondere solche Mischungen erfindungsgemäße Verwendung, in welchen es sich bei Komponente K2 um ein oder mehrere C₆₀-Fulleren-Derivate der allgemeinen Formel k2 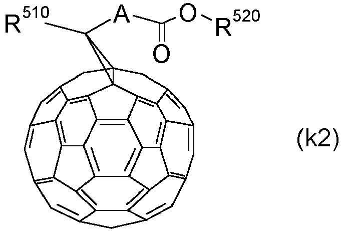 handelt,
worin bedeuten
- A: C₁-C₁₀-Alkylen,
- R⁵¹⁰: Aryl oder Aryl-C₁-C₁₀-alkyl und
- R⁵²⁰: C₁-C₁₀-Alkyl.

Zur Definition von Aryl, Aryl-C₁-C₁₀-alkyl und C₁-C₁₀-Alkyl wird auf das bereits zuvor Gesagte verwiesen.

Unter C₁-C₁₀-Alkylen ist insbesondere eine lineare Kette -(CH₂)ₙ-, mit n gleich 1, 2, 3, 4, 5, 6, 7, 8, 9 oder 10, zu verstehen.

Insbesondere finden erfindungsgemäß solche Fulleren-Derivate Verwendung, in welchen R⁵²⁰ einen C₁-C₄-Alkyl-, insbesondere einen Methylrest, bezeichnet, A für eine Propylen-Kette -(CH₂)₃- und R⁵¹⁰ für ein gegebenenfalls substituiertes Phenyl oder 2-Thienyl steht. Vorzugsweise handelt es sich bei dem Fulleren-Derivat um [6,6]-Phenyl-C₆₁-butylsäuremethylester ("PCBM").

Besonders bevorzugt zu verwendende Verbindungen der Formel k1 ergeben sich durch Kombination der bevorzugten Donorgruppierungen D01 bis D14 mit den bevorzugten Akzeptorgruppierungen A01 bis A09. Die daraus resultierenden Verbindungen ergeben sich in vereinfachender Schreibweise zu
D01-A01, D01-A02, D01-A03, D01-A04, D01-A05, D01-A06, D01-A07, D01-A08, D01-A09,
D02-A01, D02-A02, D02-A03, D02-A04, D02-A05, D02-A06, D02-A07, D02-A08, D02-A09,
D03-A01, D03-A02, D03-A03, D03-A04, D03-A05, D03-A06, D03-A07, D03-A08, D03-A09,
D04-A01, D04-A02, D04-A03, D04-A04, D04-A05, D04-A06, D04-A07, D04-A08, D04-A09,
D05-A01, D05-A02, D05-A03, D05-A04, D05-A05, D05-A06, D05-A07, D05-A08, D05-A09,
D06-A01, D06-A02, D06-A03, D06-A04, D06-A05, D06-A06, D06-A07, D06-A08, D06-A09,
D07-A01, D07-A02, D07-A03, D07-A04, D07-A05, D07-A06, D07-A07, D07-A08, D07-A09,
D08-A01, D08-A02, D08-A03, D08-A04, D08-A05, D08-A06, D08-A07, D08-A08, D08-A09,
D09-A01, D09-A02, D09-A03, D09-A04, D09-A05, D09-A06, D09-A07, D09-A08, D09-A09,
D10-A01, D10-A02, D10-A03, D10-A04, D10-A05, D10-A06, D10-A07, D10-A08, D10-A09,
D11-A01, D11-A02, D11-A03, D11-A04, D11-A05, D11-A06, D11-A07, D11-A08, D11-A09,
D12-A01, D12-A02, D12-A03, D12-A04, D12-A05, D12-A06, D12-A07, D12-A08, D12-A09,
D13-A01, D13-A02, D13-A03, D13-A04, D13-A05, D13-A06, D13-A07, D13-A08, D13-A09,
D14-A01, D14-A02, D14-A03, D14-A04, D14-A05, D14-A06, D14-A07, D14-A08 und D14-A09.

Ganz besonders bevorzugt sind zu verwenden die Verbindungen der Kombination
D01-A01, D01-A02, D01-A03, D01-A04, D01-A05, D01-A06, D01-A07, D01-A08, D01-A09,
D02-A01, D02-A02, D02-A03, D02-A04, D02-A05, D02-A06, D02-A07, D02-A08, D02-A09,
D03-A01, D03-A02, D03-A03, D03-A04, D03-A05, D03-A06, D03-A07, D03-A08, D03-A09,
D04-A01, D04-A02, D04-A03, D04-A04, D04-A05, D04-A06, D04-A07, D04-A08, D04-A09,
D05-A01, D05-A02, D05-A03, D05-A04, D05-A05, D05-A06, D05-A07, D05-A08, D05-A09,
D06-A01, D06-A02, D06-A03, D06-A04, D06-A05, D06-A06, D06-A07, D06-A08 und D06-A09.
Explizit sind nachfolgend gezeigt die Verbindungen D01-A01, D01-A02, D01-A03, D01-A04, D01-A05, D01-A06, D01-A07, D01-A08 und D01-A09 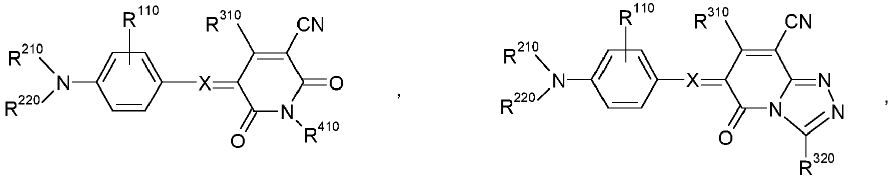 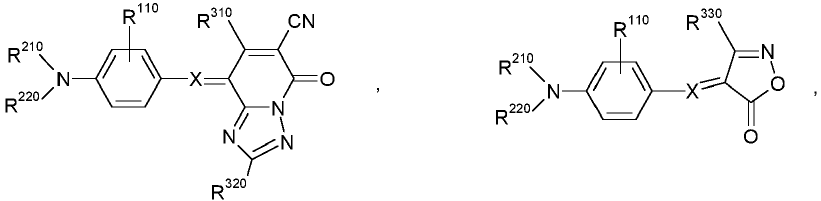 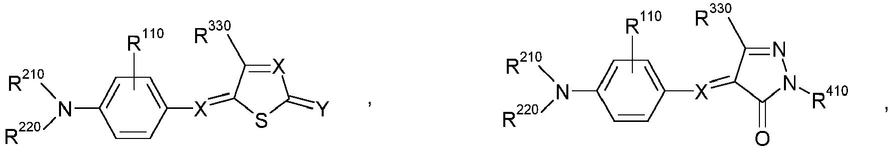 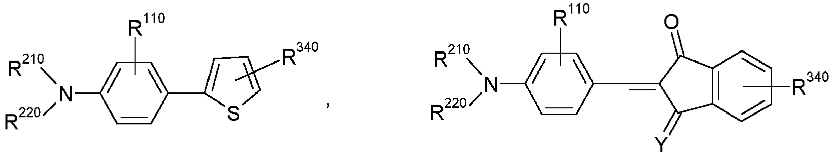
und 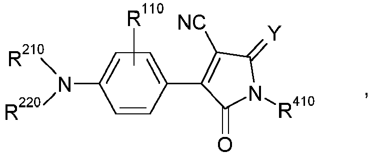 die Verbindungen D02-A01, D02-A02, D02-A03, D02-A04, D02-A05, D02-A06, D02-A07, D02-A08 und D02-A09 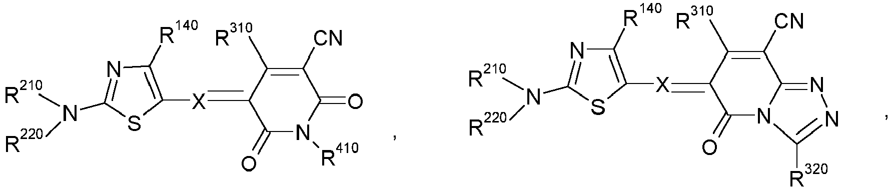 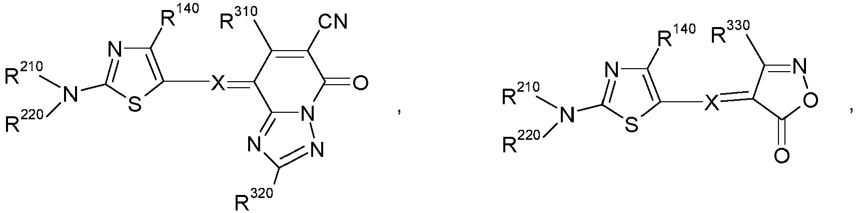 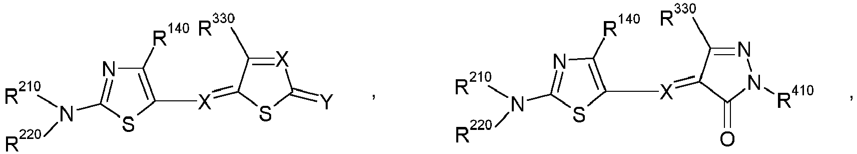 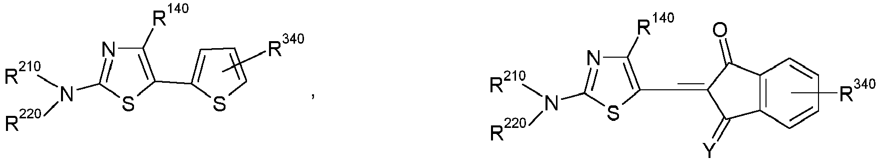 und 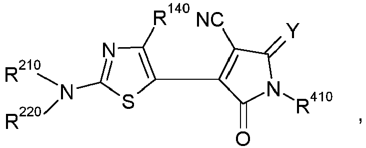 die Verbindungen D03-A01, D03-A02, D03-A03, D03-A04, D03-A05, D03-A06, D03-A07, D03-A08 und D03-A09 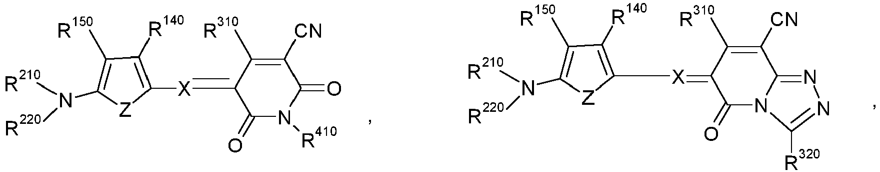 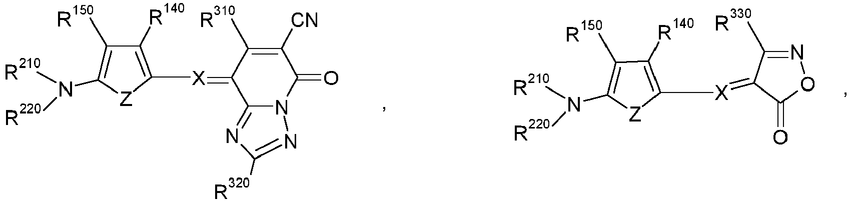 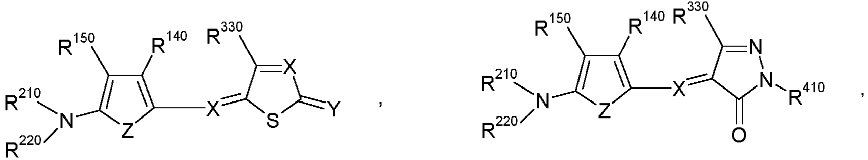 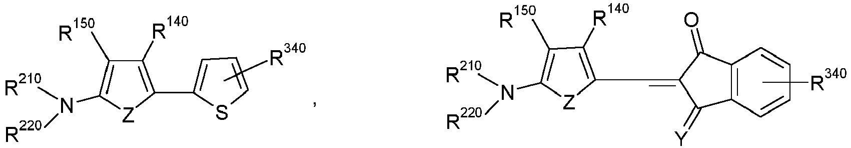 und 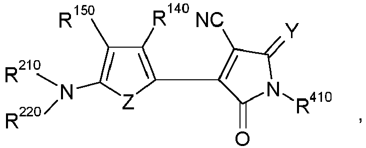 die Verbindungen D04-A01, D04-A02, D04-A03, D04-A04, D04-A05, D04-A06, D04-A07, D04-A08 und D04-A09 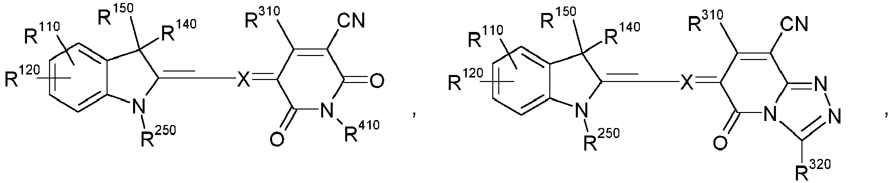 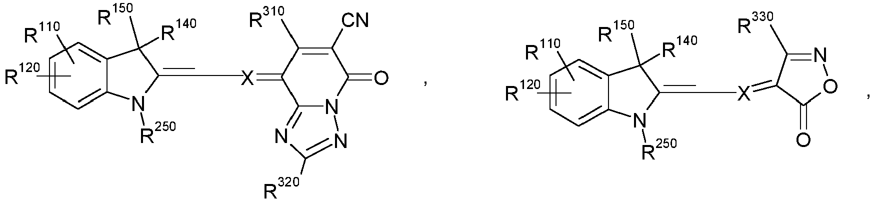 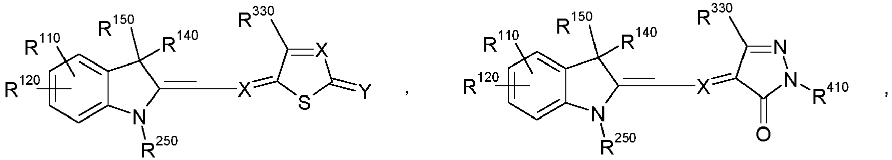 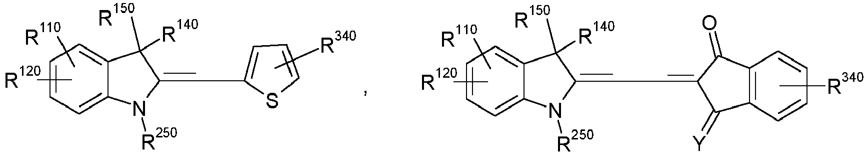 und 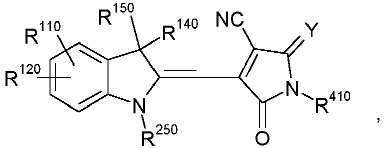 die Verbindungen D05-A01, D05-A02, D05-A03, D05-A04, D05-A05, D05-A06, D05-A07, D05-A08 und D05-A09 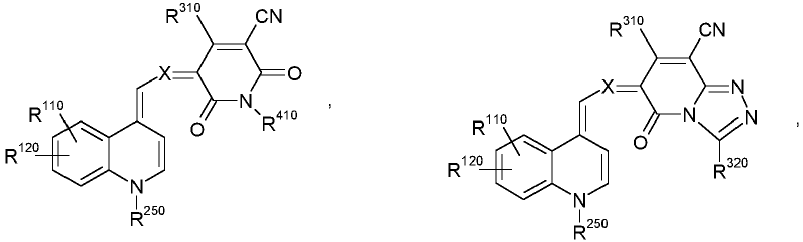 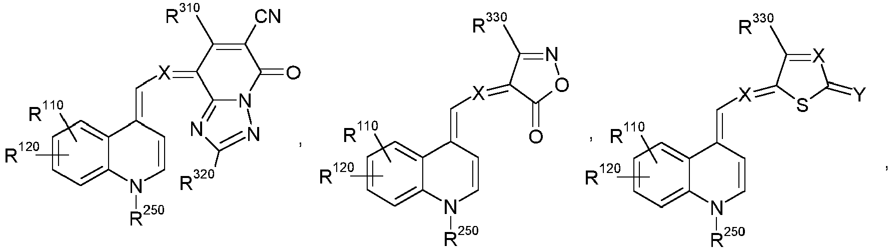 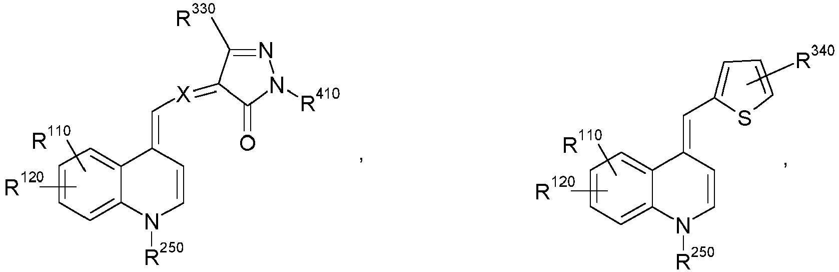 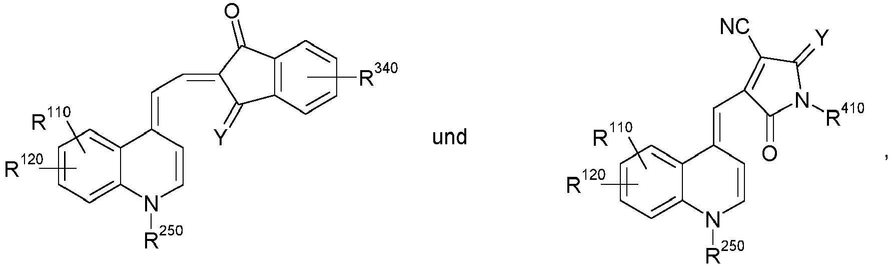 und die Verbindungen D06-A01, D06-A02, D06-A03, D06-A04, D06-A05, D06-A06, D06-A07, D06-A08 und D06-A09 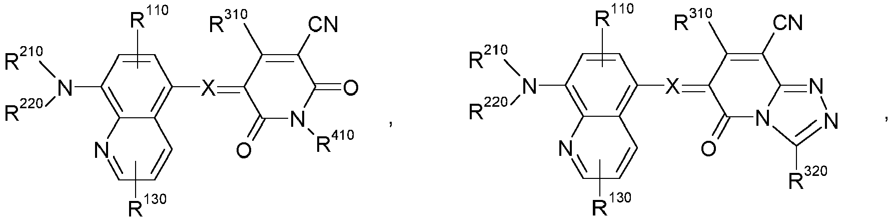 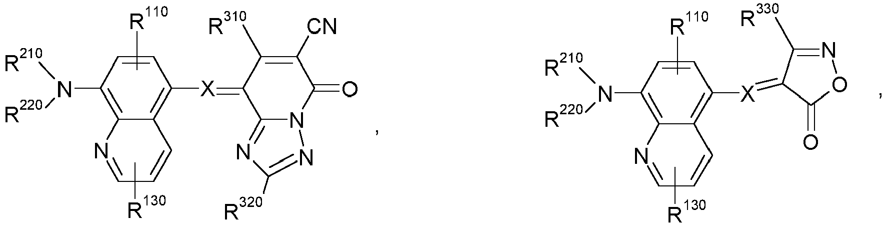 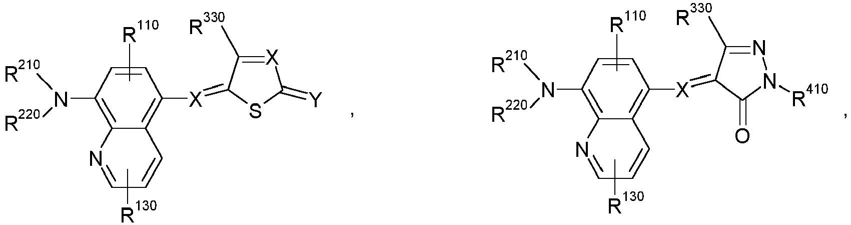 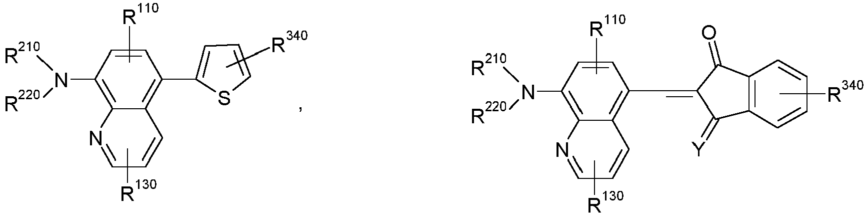 und

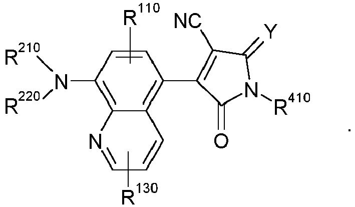

Die Variablen besitzen hierbei die zuvor aufgeführten Bedeutungen.

Herstellungsbedingt ist es im Einzelfall möglich, dass nicht eine explizit gezeigte, sondern eine dazu isomere Verbindung erhalten wird oder dass auch Mischungen von Isomeren erhalten werden. Erfindungsgemäß sollen dementsprechend auch die isomeren Verbindungen der Formel k1 bzw. die Isomeren der entsprechenden bevorzugten und besonders bevorzugten Verbindungen sowie Mischungen von Isomeren umfasst sein.

Die Synthese der Verbindungen der allgemeinen Formel k1, insbesondere die Synthese der Verbindungen der zuvor gezeigten Formeln
D01-A01, D01-A02, D01-A03, D01-A04, D01-A05, D01-A06, D01-A07, D01-A08, D01-A09,
D02-A01, D02-A02, D02-A03, D02-A04, D02-A05, D02-A06, D02-A07, D02-A08, D02-A09,
D03-A01, D03-A02, D03-A03, D03-A04, D03-A05, D03-A06, D03-A07, D03-A08, D03-A09,
D04-A01, D04-A02, D04-A03, D04-A04, D04-A05, D04-A06, D04-A07, D04-A08, D04-A09,
D05-A01, D05-A02, D05-A03, D05-A04, D05-A05, D05-A06, D05-A07, D05-A08, D05-A09,
D06-A01, D06-A02, D06-A03, D06-A04, D06-A05, D06-A06, D06-A07, D06-A08 und D06-A09
sind dem Fachmann bekannt oder lassen sich in Anlehnung an bekannte Syntheseverfahren herstellen.

Insbesondere sind hinsichtlich entsprechender Synthesen die nachfolgenden Publikationen zu nennen:
DE 195 02 702 A1;
EP 416 434 A2;
EP 509 302 A1;
"ATOP Dyes. Optimization of a Multifunctional Merocyanine Chromophore for High Refractive Index Modulation in Photorefractive Materials", F. Würthner, S. Yao, J. Schilling, R. Wortmann, M. Redi- Abshiro, E. Mecher, F. Gallego-Gomez, K. Meerholz, J. Am. Chem. Soc. 2001, 123, 2810 - 2814;
"Merocyaninfarbstoffe im Cyaninlimit: eine neue Chromophorklasse für photorefraktive Materialien; Merocyanine Dyes in the Cyanine Limit: A New Class of Chromophores for Photorefractive Materials", F. Würthner, R. Wortmann, R. Matschiner, K. Lukaszuk, K. Meerholz, Y. De Nardin, R. Bittner, C. Bräuchle, R. Sens, Angew. Chem. 1997, 109, 2933 - 2936; Angew. Chem. Int. Ed. Engl. 1997, 36, 2765 - 2768;
"Electrooptical Chromophores for Nonlinear Optical and Photorefractive Applications", S. Beckmann, K.-H. Etzbach, P. Krämer, K. Lukaszuk, R. Matschiner, A. J. Schmidt, P. Schuhmacher, R. Sens, G. Seybold, R. Wortmann, F. Würthner, Adv. Mater. 1999, 11, 536 - 541;
"DMF in Acetic Anhydride: A Useful Reagent for Multiple- Component Syntheses of Merocyanine Dyes", F. Würthner, Synthesis 1999, 2103 - 2113;
Ullmanns' Encyclopedia of industrial Chemistry, Vol. 16, 5th Edition (Ed. B. Elvers, S. Hawkins, G. Schulz), VCH 1990 im Kapitel "Methine Dyes and Pigments", S. 487 - 535 von R. Raue (Bayer AG).

Bevorzugte erfindungsgemäße Verwendung finden Mischungen, welche dadurch gekennzeichnet sind, dass die Komponente K1 in einem Anteil von 10 bis 90 Massen-% und die Komponente K2 in einem Anteil von 90 bis 10 Massen-% vorliegt, wobei sich die Anteile der Komponenten K1 und K2, jeweils bezogen auf die Gesamtmasse der Komponenten K1 und K2, zu 100 Massen-% ergänzen.

Besonders bevorzugte Verwendung finden Mischungen, welche dadurch gekennzeichnet sind, dass die Komponente K1 in einem Anteil von 20 bis 80 Massen-% und die Komponente K2 in einem Anteil von 80 bis 20 Massen-% vorliegt, wobei sich die Anteile der Komponenten K1 und K2, jeweils bezogen auf die Gesamtmasse der Komponenten K1 und K2, wiederum zu 100 Massen-% ergänzen.

Weiter werden im Rahmen der vorliegenden Erfindung organische Solarzellen und organische Photodetektoren beansprucht, welche photoaktive Schichten enthalten, die unter Verwendung der zuvor beschriebenen, die Komponenten K1 und K2 enthaltenden Mischungen, oder unter Verwendung der ebenfalls zuvor beschriebenen bevorzugten Ausführungsformen der Mischungen hergestellt worden sind.

Organische Solarzellen sind meist schichtförmig aufgebaut und umfassen in der Regel zumindest die folgenden Schichten: Elektrode, photoaktive Schicht und Gegenelektrode. Diese Schichten befinden sich in der Regel auf einem dafür üblichen Substrat. Geeignete Substrate sind z.B. oxidische Materialien, wie etwa Glas, Quartz, Keramik, SiO₂, etc., Polymere, wie etwa Polyvinylchlorid, Polyolefine, z.B. Polyethylen und Polypropylen, Polyester, Fluorpolymere, Polyamide, Polyurethane, Polyalkyl(meth)-acrylate, Polystyrol und Mischungen und Komposite davon, und Kombinationen der zuvor aufgeführten Substrate.

Als Materialien für die eine Elektrode eignen sich insbesondere Metalle, wie z.B. die Alkalimetalle Li, Na, K, Rb und Cs, die Erdalkalimetalle Mg, Ca und Ba, Pt, Au, Ag, Cu, Al, In, Metalllegierungen, z.B. auf Basis Pt, Au, Ag, Cu, etc. und spezielle Mg/Ag-Legierungen, des weiteren aber auch Alkalimetallfluoride, wie LiF, NaF, KF, RbF und CsF, und Mischungen aus Alkalimetallfluoriden und Alkalimetallen. Bevorzugt wird als Elektrode ein das einfallende Licht im Wesentlichen reflektierendes Material eingesetzt. Dazu zählen beispielsweise Metallfilme aus Al, Ag, Au, In, Mg, Mg/Al, Ca, etc.

Die Gegenelektrode besteht aus einem, gegenüber einfallendem Licht im Wesentlichen transparenten Material, z.B. ITO, dotiertes ITO, ZnO, TiO₂, Cu, Ag, Au und Pt, wobei die letztgenannten Metalle in entsprechend dünnen Schichten vorliegen.

Als "transparent" soll hierbei eine Elektrode/Gegenelektrode angesehen werden, wenn mindestens 50% der Strahlungsintensität in dem Wellenlängen-Bereich transmittiert wird, in welchem die photoaktive Schicht Strahlung absorbiert. Im Falle mehrerer photoaktiver Schichten soll eine Elektrode/Gegenelektrode als "transparent" angesehen werden, wenn mindestens 50% der Strahlungsintensität in den WellenlängenBereichen transmittiert wird, in welchen die photoaktiven Schichten Strahlung absorbieren.

Zusätzlich zur photoaktiven Schicht können eine oder mehrere weitere Schichten in den erfindungsgemäßen organischen Solarzellen und Photodetektoren vorhanden sein, z.B. Elektronen tranportierende Schichten ("ETL", electron tranporting layers) und/oder Löcher transportierende Schichten ("HTL", hole transporting layers) und/oder blockierende Schichten, z.B. Excitonen blockierende Schichten ("EBL", excition blocking layers), die üblicherweise das einfallende Licht nicht absorbieren, oder auch Schichten, welche als Ladungstransportschichten dienen und gleichzeitig die Kontaktierung zu einer oder beiden Elektroden der Solarzelle verbessern. Die ETL und HTL können auch dotiert sein, so dass sich Zellen vom p-i-n-Typ ergeben, wie sie beispielsweise in der Publikation von J. Drechsel et al., Thin Solid Films 451 - 452 (2004), 515 - 517, beschrieben sind.

Der Aufbau organischer Solarzellen ist des weiteren z.B. in den Schriften WO 2004/083958 A2, US 2005/0098726 A1 und US 2005/0224905 A1 beschrieben, worauf hier in vollem Umfang Bezug genommen wird.

Photodetektoren besitzen im Wesentlichen einen zu organischen Solarzellen analogen Aufbau, sie werden jedoch mit geeigneter Vorspannung betrieben, welche bei Einwirkung von Strahlungsenergie einen entsprechenden Stromfluss als Messantwort generiert.

Die Prozessierung der photoaktiven Schichten erfolgt beispielsweise aus Lösung. Hierbei können die Komponenten K1 und K2 bereits gemeinsam gelöst, aber auch separat als Lösung der Komponente K1 und Lösung der Komponente K2 vorliegen, wobei die Vermischung der entsprechenden Lösungen in letzterem Fall kurz vor der Aufbringung auf die darunterliegende Schicht erfolgt. Die Konzentrationen der Komponenten K1 und K2 belaufen sich in der Regel auf etwa einige g/l bis einige zehn g/l Lösungsmittel.

Als Lösungsmittel eignen sich alle Flüssigkeiten, welche rückstandsfrei verdampfen und eine ausreichende Löslichkeit für die Komponenten K1 und K2 aufweisen. Hier kommen beispielsweise in Frage aromatische Verbindungen, wie etwa Benzol, Toluol, Xylol, Mesitylen, Chlorbenzol oder Dichlorbenzol, Trialkylamine, stickstoffhaltige Heterocyclen, N,N-disubstituierte aliphatische Carbonsäureamide, wie etwa Dimethylformamid, Diethylformamid, Dimethylacetamid oder Dimethylbutyramid, N-Alkyllactame, wie etwa N-Methylpyrrolidon, lineare und cyclische Ketone, wie etwa Methylethylketon, Cyclopentanon oder Cyclohexanon, cyclische Ether, wie etwa Tetrahydrofuran, oder Alkohole, wie etwa Methanol, Ethanol, Propanol, Isopropanol oder Butanol.

Desweiteren können auch Mischungen der vorgenannten Lösungsmittel Verwendung finden.

Geeignete Methoden zur Aufbringung der erfindungsgemäßen photoaktiven Schichten aus flüssiger Phase sind dem Fachmann bekannt. Vorteilhaft zeigt sich hier insbesondere die Prozessierung mittels Spin-Coating, da die Dicke der photoaktiven Schicht in einfacher Weise durch die Menge und/oder Konzentration der verwendeten Lösung sowie die Rotationsgeschwindigkeit und/oder Rotationsdauer gesteuert werden kann. Die Prozessierung der Lösung erfolgt in der Regel bei Raumtemperatur.

Weiter ist bei geeigneter Auswahl der Komponenten K1 und K2 aber auch die Prozessierung aus der Gasphase möglich, insbesondere durch Vakuumsublimation.

Im Rahmen der vorliegenden Erfindung werden auch Mischungen beansprucht, welche als Komponenten enthalten
K1) ein oder mehrere Verbindungen der allgemeinen Formel k1

   D-A (k1)

   worin bedeuten
D eine Donorgruppierung, welche mindestens eine Kohlenstoff-Kohlenstoff- oder Kohlenstoff-Heteroatom-Doppelbindung und mindestens einen, gegebenenfalls anellierten carbo- oder heterocyclischen Ring enthält, ausgewählt ist aus der Gruppe bestehend aus: 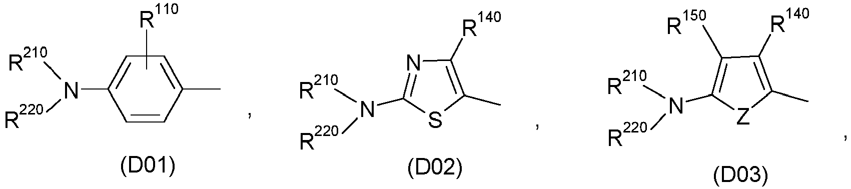 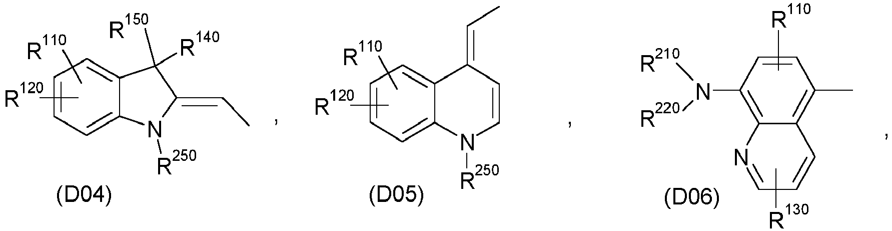 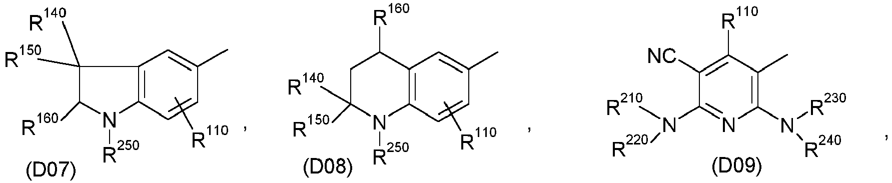 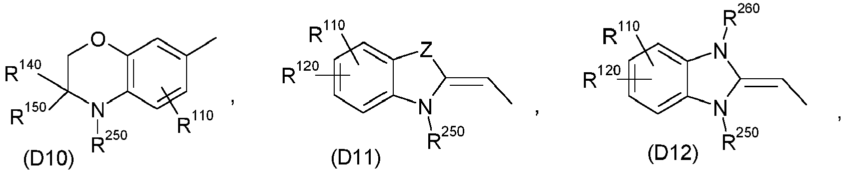 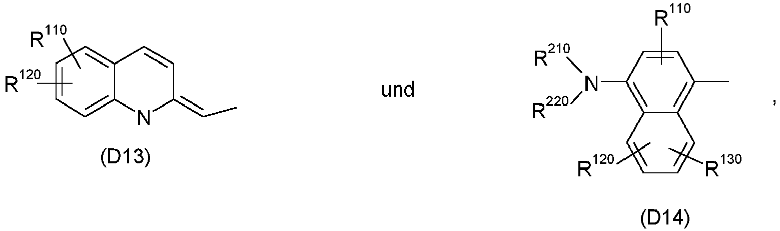
worin bedeuten
- R¹¹⁰, R¹²⁰ und R¹³⁰: unabhängig voneinander Wasserstoff, Halogen, Hydroxy, C₁-C₁₀-Alkyl, das durch ein oder zwei nicht benachbarte Sauerstoffatome unterbrochen sein kann, C₅-C₇-Cycloalkyl, C₁-C₁₀-Alkoxy, C₁-C₁₀-Alkylamino, Di(C₁-C₁₀-alkyl)amino, C₁-C₁₀-Alkylamino- oder Di(C₁-C₁₀-alkyl)aminosulfonylamino, C₁-C₁₀-Alkylsulfonylamino, Aryl, Aryl-C₁-C₁₀-alkyl, Aryloxy-C₁-C₁₀-alkyl oder einen Rest -NHCOR¹⁷⁰ oder -NHCOOR¹⁷⁰, worin R¹⁷⁰ die Bedeutung von Aryl, Aryl-C₁-C₁₀-alkyl oder C₁-C₁₀-Alkyl, das durch ein oder zwei nicht benachbarte Sauerstoffatome unterbrochen sein kann, besitzt,
- R¹⁴⁰, R¹⁵⁰ und R¹⁶⁰: unabhängig voneinander Wasserstoff, C₁-C₁₀-Alkyl, das durch ein oder zwei nicht benachbarte Sauerstoffatome unterbrochen sein kann, C₅-C₇-Cycloalkyl oder Aryl,
- R²¹⁰, R²²⁰, R²³⁰ und R²⁴⁰: unabhängig voneinander C₁-C₁₀-Alkyl, das durch ein oder zwei nicht benachbarte Sauerstoffatome unterbrochen sein kann, oder C₅-C₇-Cycloalkyl, oder R²¹⁰ und R²²⁰ und/oder R²³⁰ und R²⁴⁰ bilden zusammen mit dem Stickstoffatom, an welches sie gebunden sind, einen fünf- oder sechsgliedrigen Ring, in welchem eine der zum Stickstoffatom nicht benachbarten CH₂-Gruppen durch ein Sauerstoffatom ersetzt sein kann,
- R²⁵⁰ und R²⁶⁰: unabhängig voneinander C₁-C₁₀-Alkyl, das durch ein oder zwei nicht benachbarte Sauerstoffatome unterbrochen sein kann, C₅-C₇-Cycloalkyl, Aryl, Aryl-C₁-C₁₀-alkyl oder Aryloxy-C₁-C₁₀-alkyl
und
- Z: O oder S,

A eine Akzeptorgruppierung, welche mindestens eine Kohlenstoff-Kohlenstoff- oder Kohlenstoff-Heteroatom-Doppelbindung und mindestens einen, gegebenenfalls anellierten carbo- oder heterocyclischen Ring enthält, ausgewählt ist aus der Gruppe bestehend aus: 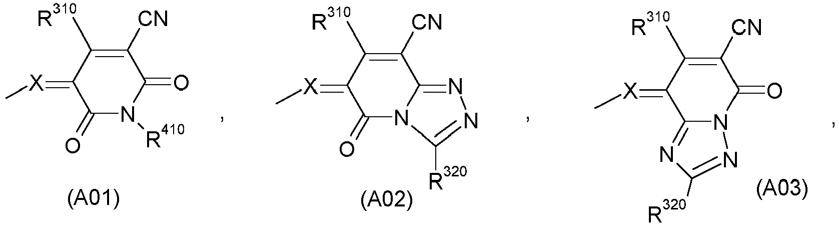 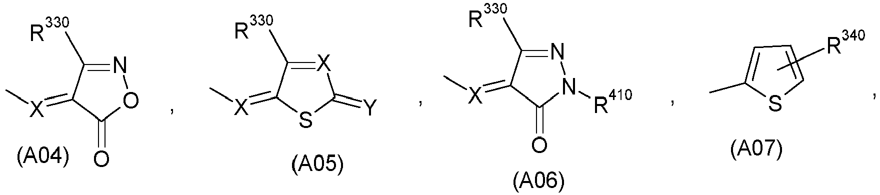 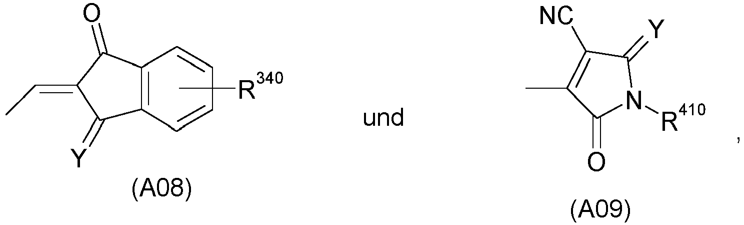 worin bedeuten
   - R³¹⁰ und R³²⁰: unabhängig voneinander Wasserstoff, C₁-C₁₀-Alkyl, das durch ein oder zwei nicht benachbarte Sauerstoffatome unterbrochen sein kann, oder C₅-C₇-Cycloalkyl,
   - R³³⁰: Wasserstoff, C₁-C₁₀-Alkyl, das durch ein oder zwei nicht benachbarte Sauerstoffatome unterbrochen sein kann, teilweise fluoriertes C₁-C₁₀-Alkyl, perfluoriertes C₁-C₁₀-Alkyl, C₅-C₇-Cyclo-alkyl oder Aryl,
   - R³⁴⁰: Wasserstoff, NO₂, CN, COR³⁵⁰, COOR³⁵⁰, SO₂R³⁵⁰ oder SO₃R³⁵⁰, worin R³⁵⁰ die Bedeutung von Aryl oder C₁-C₁₀-Alkyl besitzt,
   - R⁴¹⁰: C₁-C₁₀-Alkyl, das durch ein oder zwei nicht benachbarte Sauerstoffatome unterbrochen sein kann, C₅-C₇-Cycloalkyl, Aryl, Aryl-C₁-C₁₀-alkyl, Aryloxy-C₁-C₁₀-Alkyl, einen Rest -NHCOR⁴²⁰ oder einen Rest -N(CO R⁴²⁰)₂, worin R⁴²⁰ die Bedeutung von Aryl, Aryl-C₁-C₁₀-alkyl oder C₁-C₁₀-Alkyl, das durch ein oder zwei nicht benachbarte Sauerstoffatome unterbrochen sein kann, besitzt, und die beiden R⁴²⁰ im Rest -N(CO R⁴²⁰)₂ gleich oder voneinander verschieden sein können,
   - X: unabhängig voneinander CH oder N
   und
   - Y: O, C(CN)₂ oder C(CN)(COOR⁴³⁰), worin R⁴³⁰ die Bedeutung C₁-C₁₀-Alkyl, das durch ein oder zwei nicht benachbarte Sauerstoffatome unterbrochen sein kann, besitzt,
   und die Donorgruppierung D und die Akzeptorgruppierung A miteinander in π-Konjugation stehen,
   und
K2) ein oder mehrere Fullerene und/oder Fulleren-Derivate.

Bevorzugte erfindungsgemäße Mischungen enthalten als Komponenten
K1) ein oder mehrere Verbindungen der allgemeinen Formel k1

   D-A (k1)

   und
K2) ein oder mehrere C₆₀-Fulleren-Derivate der allgemeinen Formel k2 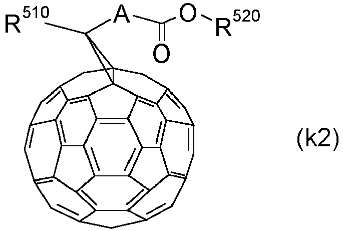 worin bedeuten
   - A: C₁-C₁₀-Alkylen,
   - R⁵¹⁰: Aryl oder Aryl-C₁-C₁₀-alkyl
   und
   - R⁵²⁰: C₁-C₁₀-Alkyl

Auf die Definition und Bevorzugungen der vorgenannten Variablen ist bereits weiter oben eingegangen worden.

Die entsprechenden ganz besonders bevorzugten Verbindungen
D01-A01, D01-A02, D01-A03, D01-A04, D01-A05, D01-A06, D01-A07, D01-A08, D01-A09,
D02-A01, D02-A02, D02-A03, D02-A04, D02-A05, D02-A06, D02-A07, D02-A08, D02-A09,
D03-A01, D03-A02, D03-A03, D03-A04, D03-A05, D03-A06, D03-A07, D03-A08, D03-A09,
D04-A01, D04-A02, D04-A03, D04-A04, D04-A05, D04-A06, D04-A07, D04-A08, D04-A09,
D05-A01, D05-A02, D05-A03, D05-A04, D05-A05, D05-A06, D05-A07, D05-A08, D05-A09,
D06-A01, D06-A02, D06-A03, D06-A04, D06-A05, D06-A06, D06-A07, D06-A08 und D06-A09
wurden bereits zuvor aufgeführt, auf sie wird auch im Bezug auf die erfindungsgemäßen Mischungen explizit Bezug genommen.

Des Weiteren, und unter Berücksichtigung der zuvor erwähnten Bevorzugungen, werden solche erfindungsgemäßen Mischungen beansprucht, welche dadurch gekennzeichnet sind, dass die Komponente K1 in einem Anteil von 10 bis 90 Massen-% und die Komponente K2 in einem Anteil von 90 bis 10 Massen-% vorliegt, wobei sich die Anteile der Komponenten K1 und K2, jeweils bezogen auf die Gesamtmasse der Komponenten K1 und K2, zu 100 Massen-% ergänzen.

Insbesondere, und unter Berücksichtigung der zuvor erwähnten Bevorzugungen, werden solche erfindungsgemäßen Mischungen beansprucht, welche dadurch gekennzeichnet sind, dass die Komponente K1 in einem Anteil von 20 bis 80 Massen-% und die Komponente K2 in einem Anteil von 80 bis 20 Massen-% vorliegt, wobei sich die Anteile der Komponenten K1 und K2, jeweils bezogen auf die Gesamtmasse der Komponenten K1 und K2, zu 100 Massen-% ergänzen.

Die Erfindung wird anhand der folgenden, nicht einschränkenden Beispiele näher erläutert.

### Beispiele:

Eingesetzte Verbindungen als Komponente K1 in den erfindungsgemäßen photoaktiven Schichten:

### Verbindung der Formel D02-A01:

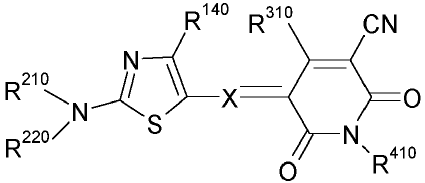

| Kurzbezeichnung | X | R²¹⁰ | R²²⁰ | R¹⁴⁰ | R³¹⁰ | R⁴¹⁰ |
|---|---|---|---|---|---|---|
| TAOP | CH | n-Butyl | n-Butyl | Phenyl | Methyl | n-Butyl |

### Verbindung der Formel D02-A04:

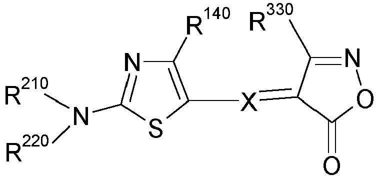

| Kurzbezeichnung | X | R²¹⁰ | R²²⁰ | R¹⁴⁰ | R³³⁰ |
|---|---|---|---|---|---|
| TAOX | CH | n-Butyl | n-Butyl | Phenyl | Phenyl |

### Verbindungen der Formel D03-A01:

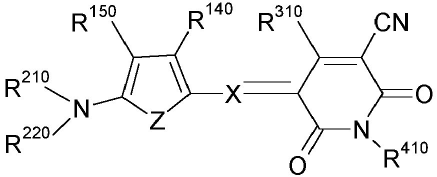

| Kurzbezeichnung | Z | X | R²¹⁰ | R²²⁰ | R¹⁴⁰ | R¹⁵⁰ | R³¹⁰ | R⁴¹⁰ | |
|---|---|---|---|---|---|---|---|---|---|
| AFOP | O | CH | n-Butyl | n-Butyl | H | H | Methyl | n-Butyl | |
| ATOP1 | S | CH | n-Butyl | n-Butyl | H | H | Methyl | n-Butyl | |
| ATOP4 | S | CH | n-Butyl | n-Butyl | H | H | Methyl | 2-Ethylhexyl | |
| ATOP7 | S | CH | Ethyl | n-Butyl | H | H | Methyl | n-Butyl | |
| ATOP8 | S | CH | Ethyl | n-Butyl | H | H | Methyl | n-Hexyl | |

### Verbindung der Formel D03-A04:

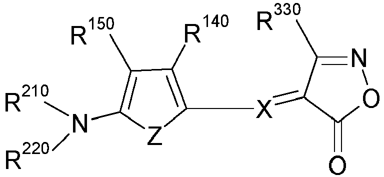

| Kurzbezeichnung | Z | X | R²¹⁰ | R²²⁰ | R¹⁴⁰ | R¹⁵⁰ | R³³⁰ |
|---|---|---|---|---|---|---|---|
| AFOX | O | CH | n-Butyl | n-Butyl | H | H | Phenyl |

### Verbindungen der Formel D04-A01:

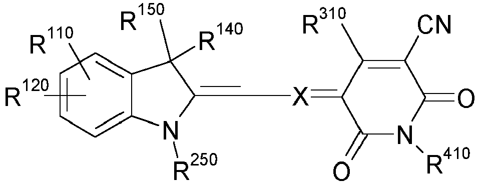

| Kurzbezeichnung | X | R²⁵⁰ | R¹¹⁰ | R¹²⁰ | R¹⁴⁰ | R¹⁵⁰ | R³¹⁰ | R⁴¹⁰ |
|---|---|---|---|---|---|---|---|---|
| IDOP301 | CH | n-Butyl | H | H | Methyl | Methyl | Methyl | 2-Ethylhexyl |
| IDOP305 | CH | Isopropyl | H | H | Methyl | Methyl | Methyl | 2-Ethylhexyl |

### Verbindungen der Formel D04-A05:

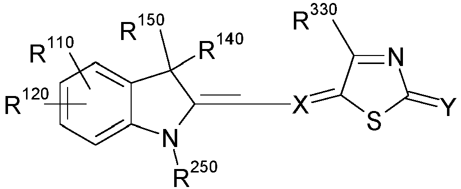

| Kurzbezeichnung | X | R²⁵⁰ | R¹¹⁰ | R¹²⁰ | R¹⁴⁰ | R¹⁵⁰ | R³³⁰ | Y |
|---|---|---|---|---|---|---|---|---|
| IDTA303 | CH | Phenyl | H | H | Methyl | Methyl | Phenyl | C(CN)₂ |
| IDTA304 | CH | Benzyl | H | H | Methyl | Methyl | tert.-Butyl | C(CN)₂ |
| IDTA322 | CH | 7-Phenoxyheptyl | H | H | Methyl | Methyl | Phenyl | C(CN)₂ |

Eingesetzte Verbindung als Komponente K2 in den erfindungsgemäßen photoaktiven Schichten:

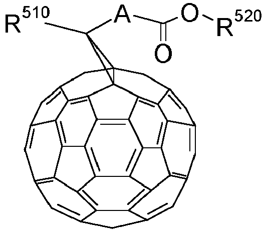

| Kurzbe-zeichnung | R⁵¹⁰ | R⁵²⁰ | A |
|---|---|---|---|
| PCBM | Phenyl | Methyl | (CH₂)₃ |

### Herstellung der Solarzellen:

Allgemeiner Aufbau: üblicherweise erfolgt die Aufbringung der Schichten in der Reihenfolge (2) bzw. (3) bis (6). Im Falle kommerziell erhältlicher, mit ITO (Indiumzinnoxid) beschichteter Glasplatten ist die transparente Elektrode (2) bereits auf das Glassubstrat (1) aufgebracht.

| | |
|---|---|
| (1) Transparentes Substrat: | Glasplatte |
| (2) Transparente Elektrode: | 140 nm |
| (3) Lochinjektionsschicht: | 0 - 100 nm |
| | |
| (4) Photoaktive Schicht: | 30 - 500 nm |
| | |
| (5) Metallelektrode: | 0 - 200 nm |
| (6) Verkapselung: | für Versuchsaufbau optional |

| | |
|---|---|
| (1) + (2): Transparentes Substrat und transparente Elektrode | |

Es wurden mit circa 140 nm ITO (Indiumzinnoxid) beschichtete Glasplatten der Firma Merck verwendet. Der Schichtwiderstand des ITOs betrug weniger als 15 Ω.

### (3): Lochinjektionsschicht:

Zur Verbesserung der Oberflächenbeschaffenheit und der Lochinjektion der ITO-Anode wurde die wässrige Suspension BAYTRON P VP I4083 der Firma H. C. Stark verwendet. In der Suspension ist neben PEDOT auch das Polymer Poly(styrolsulfonsäure) (PSSH) enthalten. Die PEDOT-Schichtdicke betrug ca. 35 nm. Nach dem Spin-Coaten wurden die PEDOT-Schichten zwei Minuten bei 110 °C ausgeheizt um Wasserreste zu entfernen.

### (4): Photoaktive Schicht

Als Komponente K1 wurden entweder Reinverbindungen der Formel k1 oder Mischungen von Verbindungen der Formel k1 verwendet (die Verbindungen der Formeln k1 werden im Folgenden auch als "Merocyanine" bezeichnet), welche nach an sich bekannten Synthesen hergestellt worden waren. Als Komponente K2 wurde das zuvor gezeigte Fulleren-Derivat [6,6]-PCBM (engl.: [6,6]-phenyl-C₆₁ butyric acid methyl ester) der Firma Nano-C verwendet. Zur Herstellung der photoaktiven Bulk-Heterojunction-Schichten der untersuchten Solarzellen wurden Mischungen der Lösungen der einzelnen Komponenten K1 und K2 in Chlorbenzol mittels Spin-Coating aufgetragen. Die Lösungen der einzelnen Komponenten wurden kurz vor der Schichtherstellung in einer Konzentration von 20 g/L angesetzt und über Nacht bei 50 bis 70 °C gerührt. Direkt vor dem Lackschleudern wurden die Lösungen der einzelnen Komponenten vereinigt und gut gemischt. Die Schichtdicken wurden hauptsächlich durch die Rotationsgeschwindigkeit und weniger über die Rotationsdauer kontrolliert. Die Rotationsgeschwindigkeit wurde im Bereich 450 bis 2200 U/min variiert, die Rotationsdauern betrugen zwischen 20 und 40 Sekunden. Das Lösungsmittel verdampfte beim anschließenden Tempern und/oder während des für Schritt (5) notwendigen Evakuierens.

### (5): Metallelektrode

Zum Aufdampfen der Metallelektrode (sogenannte "Top-Elektrode" da sie vor der Verkapselungsschicht die letzte aktive Schicht im Aufbau darstellt) wurden Aluminium, Barium und Silber in Granulatform mit einem Reinheitsgehalt von 99,9 % verwendet. Die Top-Elektrode wurde unter Hochvakuum von wenigstens 5 x 10⁻⁶ hPa aufgedampft, wobei die Verdampfungsrate anfangs klein gehalten (0,2 bis 0,5 nm/s) und erst mit zunehmender Schichtdicke auf 1,0 bis 1,5 nm/s erhöht wurde. Die aufgedampften Aluminiumschichten besaßen eine Dicke von etwa 150 nm.

Folgende Abkürzungen werden verwendet:
- L:: Dicke der photoaktiven Schicht
- V_{OC}:: Leerlaufspannung ("OC" steht für "open circuit")
- V_{bi}:: Built-in-Spannung
- V_{OC,ideal}:: theoretische Leerlaufspannung
- J_{SC}:: Kurzschlussstromdichte ("SC" steht für "short circuit")
- FF:: Füllfaktor
- η:: Effizienz

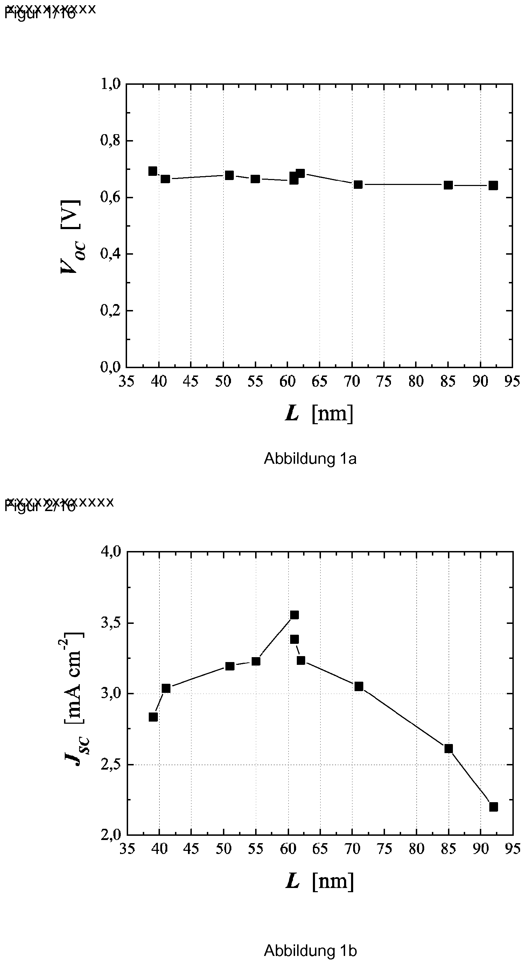

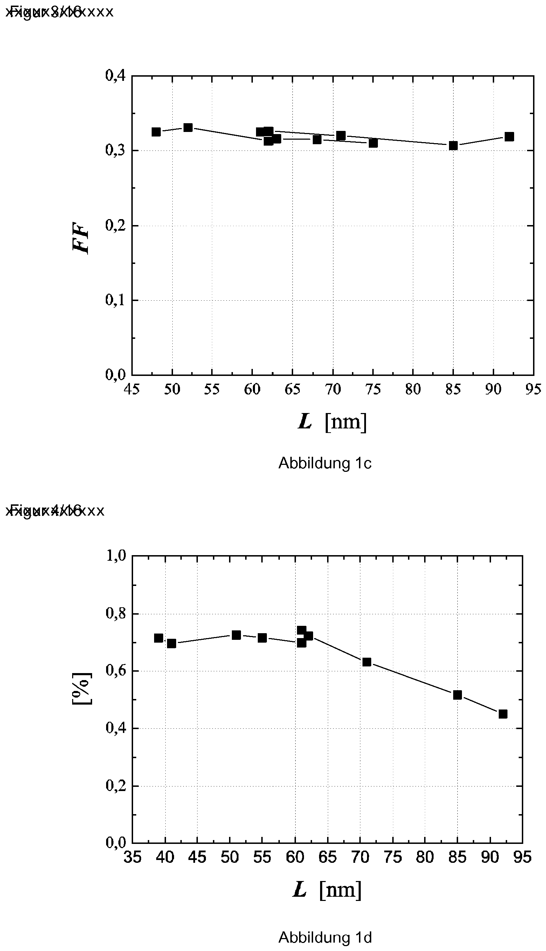

Abbildungen 1a bis 1d: Darstellung der Abhängigkeit der Kenngrößen von ATOP4: PCBM-Solarzellen mit einem ATOP4:PCBM-Massenverhältnis von 1:3 von der Schichtdicke L der photoaktiven Schicht.
- Abbildung 1a:: Abhängigkeit der Leerlaufspannung V_{OC} (in V) von der Schicktdicke L (in nm)
- Abbildung 1b:: Abhängigkeit der Kurzschlussstromdichte J_{SC} (in mA/cm²) von der Schichtdicke L (in nm)
- Abbildung 1c:: Abhängigkeit des Füllfaktors FF von der Schichtdicke L (in nm)
- Abbildung 1d:: Abhängigkeit der Effizienz (in %) von der Schichtdicke L (in nm)

Abbildungen 2a bis 2d: Darstellung der Abhängigkeit der Kenngrößen von Solarzellen mit den ATOP-Derivaten ATOP1, ATOP4, ATOP7 und ATOP8 vom Massenanteil ATOP-Derivat: PCBM (der Massenanteil an PCBM und jeweiligem ATOP-Derivat ergänzt sich zu 100 %).

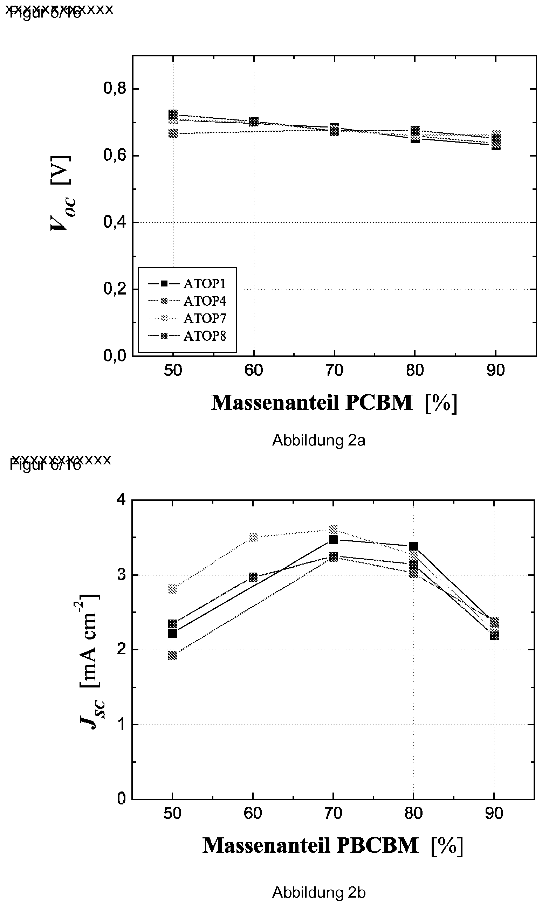

- Abbildung 2a:: Abhängigkeit der Leerlaufspannung V_{OC} (in V) vom Massenanteil PCBM (in %)
- Abbildung 2b:: Abhängigkeit der Kurzschlussstromdichte J_{SC} (in mA/cm²) vom Massenanteil PCBM (in %)

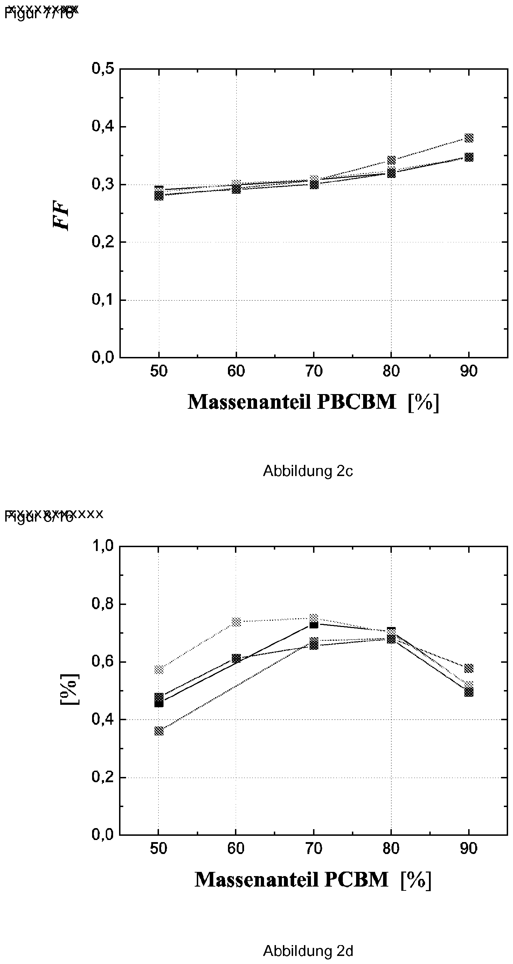

- Abbildung 2c:: Abhängigkeit des Füllfaktors FF vom Massenanteil PCBM (in %)
- Abbildung 2d:: Abhängigkeit der Effizienz (in %) vom Massenanteil PCBM (in %)

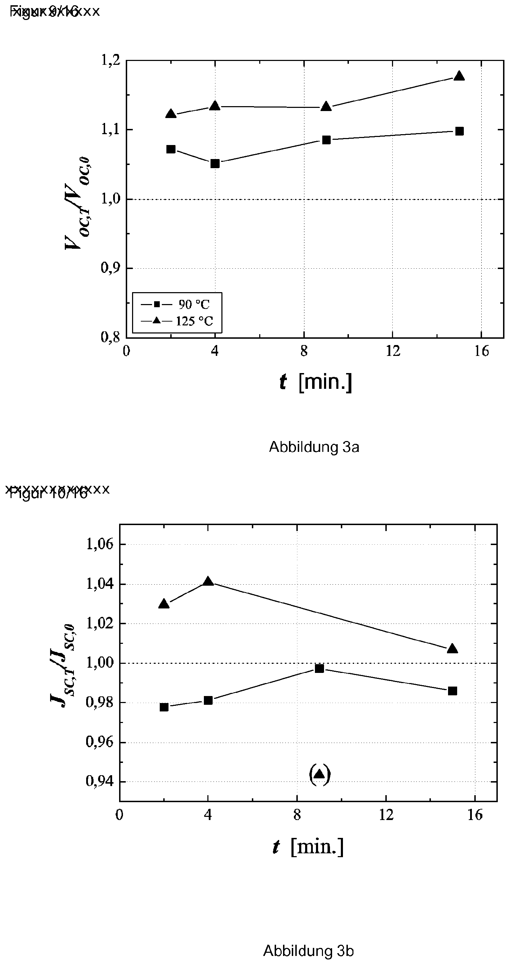

Abbildungen 3a bis 3d: Darstellung der Abhängigkeit der relativen Kenngrößen von ATOP7:PCBM-Solarzellen mit einem Massenverhältnis für ATOP7:PCBM von 3:7 von der Temperdauer t (in min). Die relativen Kenngrößen wurden durch Verhältnisbildung der jeweiligen Kenngröße nach t min Temperung zum Startwert der Kenngröße ohne Temperung ermittelt. Die Temperungen wurden bei 95°C und 125°C durchgeführt.

Die Startwerte ohne Temperung sind den Abbildungen 2a bis 2d zu entnehmen und betragen:
V_{OC,0}= 0,63 V; J_{SC,0}= 3,0 mA cm⁻²; FF₀ = 0,32; η₀ = 0,60 %

Die Werte der jeweiligen Kenngröße nach t min Temperung sind mit V_{OC,T}, J_{SC,T}, FF_{T} und η_{T} bezeichnet.
- Abbildung 3a:: Abhängigkeit des Verhältnisses V_{OC,T}/V_{OC,0} von der Temperzeit t (in min)
- Abbildung 3b:: Abhängigkeit des Verhältnisses J_{SC,T}/J_{SC,0} von der Temperzeit t (in min)

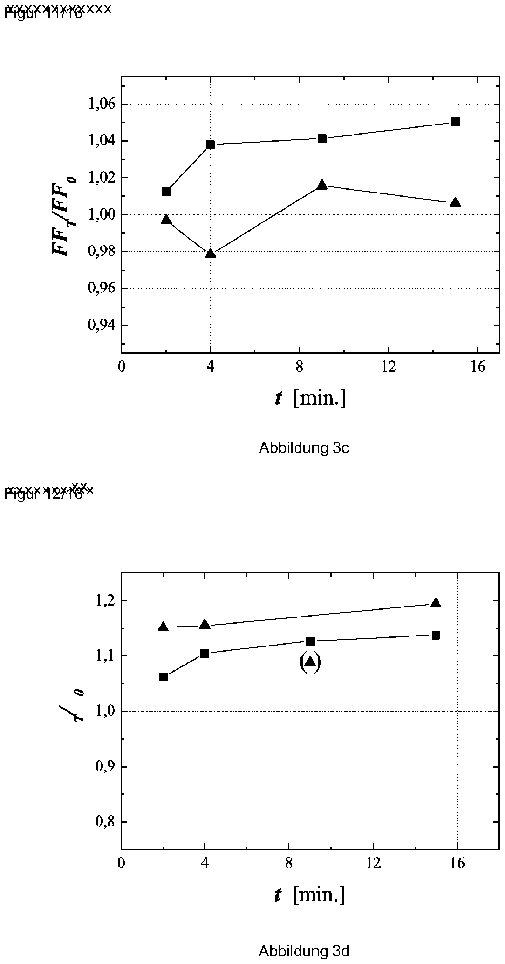

- Abbildung 3c:: Abhängigkeit des Verhältnisses FF_{T}/FF₀ von der Temperzeit t (in min)
- Abbildung 3d:: Abhängigkeit des Verhältnisses η_{T}/η₀ von der Temperzeit t (in min)

Durch Tempern der Schichten (nach Abscheidung der Elektroden) können die Kenngrößen der Zellen etwas verbessert werden.

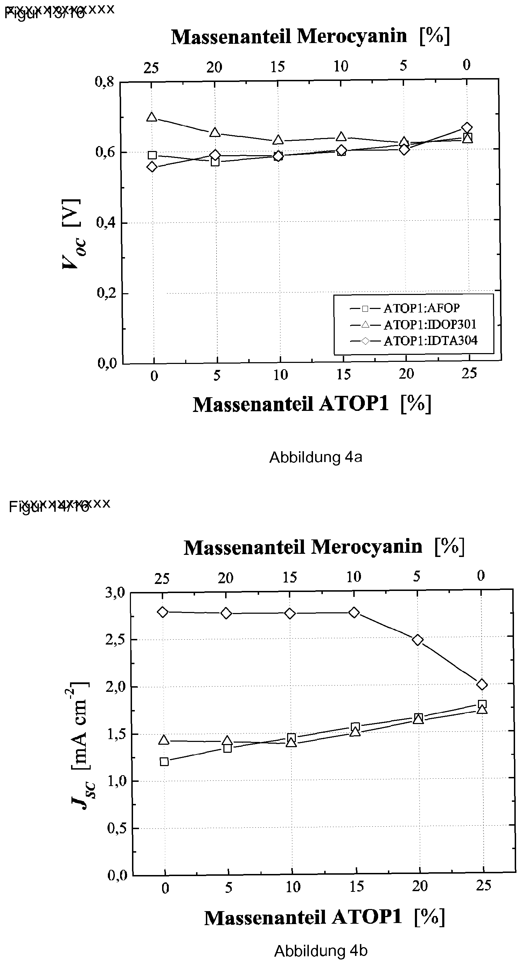

Abbildungen 4a bis 4d: Darstellung der Abhängigkeit der Kenngrößen von Solarzellen vom Massenverhältnis ATOP1:AFOP, ATOP1:IDOP301 und ATOP1:IDTA304 in der photoaktiven Schicht. In allen Fällen wurden ein Massenverhältnis von (ATOP1:AFOP): PCBM, (ATOP1:IDOP301):PCBM und (ATOP1:IDTA304):PCBM von 1:3 eingestellt. Der Massenanteil der Verbindungen AFOP, IDOP301 und IDTA304 ist der oberen Abszisse (Beschriftung "Massenanteil Merocyanin [%]"), der Massenanteil der Verbindung ATOP1 der unteren Abszisse zu entnehmen. Beide Massenanteile ergänzen sich jeweils zu 25%, der Massenanteil an PCBM ergänzt sich jeweils zu 100% (entsprechend dem zuvor angeführten Verhältnis von 1:3).
- Abbildung 4a:: Abhängigkeit der Leerlaufspannung V_{OC} (in V) vom Verhältnis des Massenanteils ATOP1 (in %) zum Massenanteil der jeweiligen Verbindungen AFOP, IDOP301 und IDTA304 (in %)
- Abbildung 4b:: Abhängigkeit der Kurzschlussstromdichte J_{SC} (in mA/cm²) vom Verhältnis des Massenanteils ATOP1 (in %) zum Massenanteil der jeweiligen Verbindungen AFOP, IDOP301 und IDTA304 (in %)

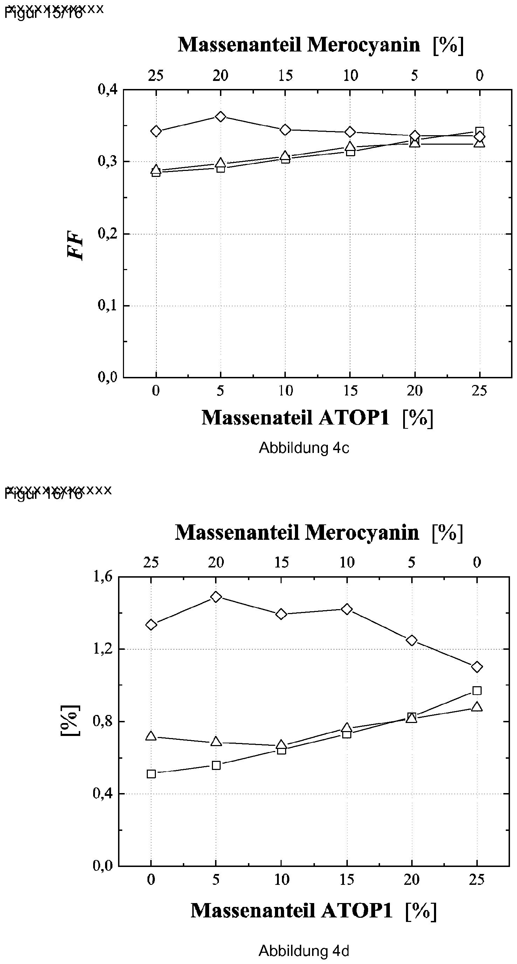

- Abbildung 4c:: Abhängigkeit des Füllfaktors FF vom Verhältnis des Massenanteils ATOP1 (in %) zum Massenanteil der jeweiligen Verbindungen AFOP, IDOP301 und IDTA304 (in %)
- Abbildung 4d:: Abhängigkeit der Effizienz (in %) vom Verhältnis des Massenanteils ATOP1 (in %) zum Massenanteil der jeweiligen Verbindungen AFOP, IDOP301 und IDTA304 (in %)

In nachfolgender Tabelle sind die Kenngrößen von Solarzellen mit verschiedenen Verbindungen der Formel D-A ("Merocyanin") aufgeführt. Dabei wurde in allen Fällen ein Massenverhältnis von Merocyanin:PCBM von 1:3 eingestellt.

| Merocyanin | L [nm] | V_{OC} [V] | V_{bi} [V] | V_{OC,ideal} [V] | J_{SC} [mA/cm²] | FF | η [%] |
|---|---|---|---|---|---|---|---|
| ATOP1 | 66 | 0,63 | 0,66 | 1,57 | 1,79 | 0,34 | 0,97 |
| AFOP | 61 | 0,59 | 0,62 | 1,52 | 1,21 | 0,29 | 0,51 |
| AFOX | 63 | 0,29 | 0,36 | > 1,61 | 0,28 | 0,23 | 0,05 |
| IDOP301 | 71 | 0,70 | 0,77 | 1,73 | 1,43 | 0,29 | 0,72 |
| IDTA304 | n.b. ¹⁾ | 0,56 | n.b. ¹⁾ | 1,52 | 2,80 | 0,34 | 1,34 |
| TAOP | 71 | 0,49 | 0,58 | 1,82 | 0,45 | 0,27 | 0,15 |
| TAOX | 61 | 0,26 | 0,53 | > 1,85 | 0,10 | 0,27 | 0,02 |

| | | | | | | | |
|---|---|---|---|---|---|---|---|
| ¹⁾ nicht bestimmt | | | | | | | |

In den zuvor untersuchten photoaktiven Schichten wirkte die Komponente K1 (d.h. die ein oder mehreren Merocyanine der Formel k1) als Elektronendonor und die Komponente K2 (d.h. das Fulleren-Derivat) als Elektronenakzeptor.

Analog zu den vorherigen Versuchen wurden organische Solarzellen hergestellt, in welchen die photoaktive Schicht aus der Verbindung ATOP4 als Komponente K1 und der Verbindung Poly(3-hexyl-thiophen) ("P3HT") als Komponente K2 bestand, wobei letztere Verbindung üblicherweise Elektronendonor ist. Der Massenanteil von ATOP4 zu P3HT wurde im Bereich 1:3, 1:1 und 3:1 variiert. Die entsprechenden Effizienzen η ergaben sich zu 0,02%, 0,03% und 0%. Es wurde festgestellt, dass P3HT in dieser Kombination wiederum als Elektronendonor, ATOP4 dagegen als Elektronenakzeptor fungiert.

## Patentansprüche

1. Verwendung von Mischungen, enthaltend als Komponenten
K1) ein oder mehrere Verbindungen der allgemeinen Formel k1
D-A (k1)
als Elektronendonor bzw. Elektronenakzeptor, worin bedeuten
D eine Donorgruppierung, welche mindestens eine Kohlenstoff-Kohlenstoff- oder Kohlenstoff-Heteroatom-Doppelbindung und mindestens einen, gegebenenfalls anellierten carbo- oder heterocyclischen Ring enthält,
A eine Akzeptorgruppierung, ausgewählt aus der Gruppe bestehend aus: 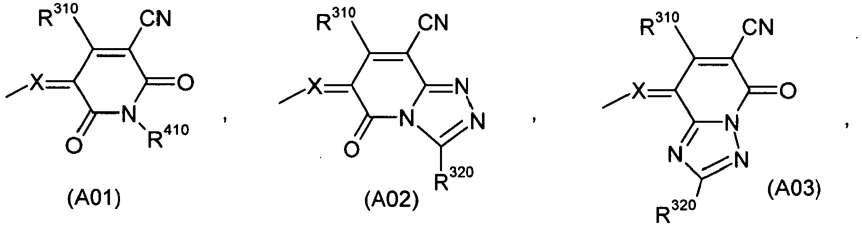 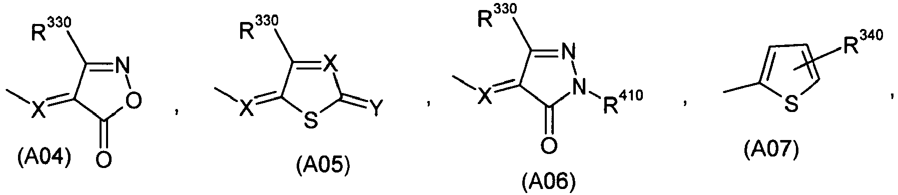 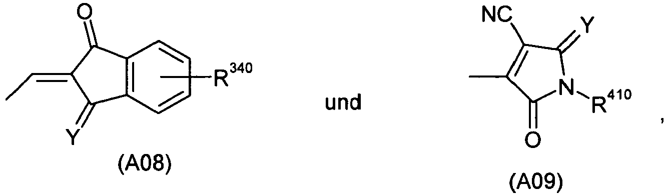
worin bedeuten
R³¹⁰ und R³²⁰ unabhängig voneinander Wasserstoff, C₁-C₁₀-Alkyl, das durch ein oder zwei nicht benachbarte Sauerstoffatome unterbrochen sein kann, oder C₅-C₇-Cycloalkyl,
R³³⁰ Wasserstoff, C₁-C₁₀-Alkyl, das durch ein oder zwei nicht benachbarte Sauerstoffatome unterbrochen sein kann, teilweise fluoriertes C₁-C₁₀-Alkyl, perfluoriertes C₁-C₁₀-Alkyl, C₅-C₇-Cycloalkyl oder Aryl,
R³⁴⁰ Wasserstoff, NO₂, CN, COR³⁵⁰, COOR³⁵⁰, SO₂R³⁵³ oder SO₃R³⁵⁰, worin R³⁵⁰ die Bedeutung von Aryl oder C₁-C₁₀-Alkyl besitzt,
R⁴¹⁰ C₁-C₁₀-Alkyl, das durch ein oder zwei nicht benachbarte Sauerstoffatome unterbrochen sein kann, C₅-C₇-Cycloalkyl, Aryl, Aryl-C₁-C₁₀-alkyl, Aryloxy-C₁-C₁₀-Alkyl, einen Rest -NHCOR⁴²⁰ oder einen Rest -N(CO R⁴²⁰)², worin R⁴²⁰ die Bedeutung von Aryl, Aryl-C₁-C₁₀-alkyl oder C₁-C₁₀-Alkyl, das durch ein oder zwei nicht benachbarte Sauerstoffatome unterbrochen sein kann, besitzt, und die beiden R⁴²⁰ im Rest -N(CO R⁴²⁰)₂ gleich oder voneinander verschieden sein können,
X unabhängig voneinander CH oder N und
Y O, C(CN)₂ oder C(CN)(COOR⁴³⁰), worin R⁴³⁰ die Bedeutung C₁-C₁₀-Alkyl, das durch ein oder zwei nicht benachbarte Sauerstoffatome unterbrochen sein kann, besitzt,
und die Donorgruppierung D und die Akzeptorgruppierung A miteinander in π-Konjugation stehen,
und
K2) ein oder mehrere Verbindungen, welche gegenüber Komponente K1) entsprechend als Elektronenakzeptor bzw. Elektronendonor wirken,
zur Herstellung von photoaktiven Schichten für organische Solarzellen und organische Photodetektoren.

2. Verwendung nach Anspruch 1, **dadurch gekennzeichnet, dass** die Donorgruppierung D in den ein oder mehreren Verbindungen der allgemeinen Formel k1 ausgewählt ist aus der Gruppe bestehend aus: 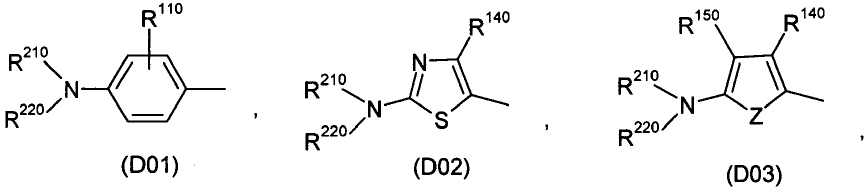 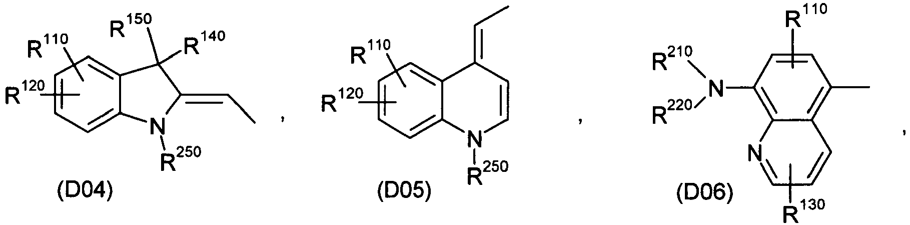 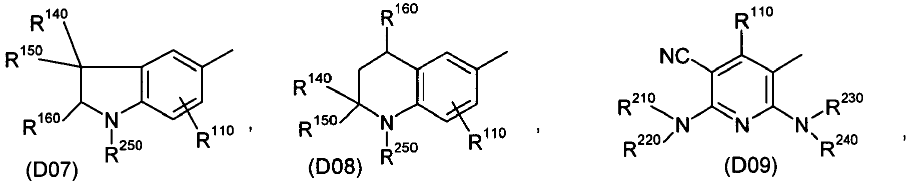 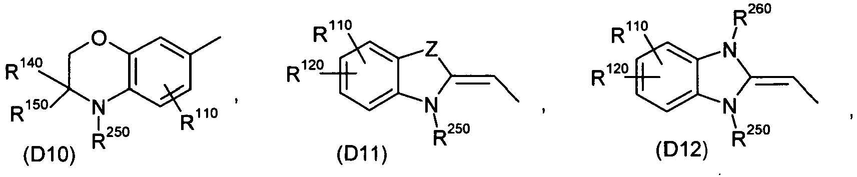 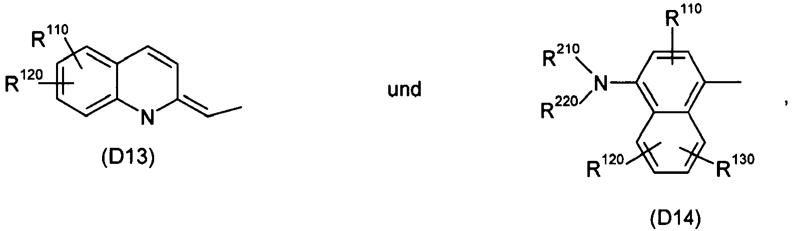 worin bedeuten
R¹¹⁰, R¹²⁰ und R¹³⁰ unabhängig voneinander Wasserstoff, Halogen, Hydroxy, C₁-C₁₀-Alkyl, das durch ein oder zwei nicht benachbarte Sauerstoffatome unterbrochen sein kann, C₅-C₇-Cycloalkyl, C₁-C₁₀-Alkoxy, C₁-C₁₀-Alkylamino, Di(C₁-C₁₀-alkyl)amino, C₁-C₁₀-Alkylamino- oder Di(C₁-C₁₀-alkyl)aminosulfonylamino, C₁-C₁₀-Alkylsulfonylamino, Aryl, Aryl-C₁-C₁₀-alkyl, Aryloxy-C₁-C₁₀-alkyl oder einen Rest - NHCOR¹⁷⁰ oder -NHCOOR¹⁷⁰, worin R¹⁷⁰ die Bedeutung von Aryl, Aryl-C₁-C₁₀-alkyl oder C₁-C₁₀-Alkyl, das durch ein oder zwei nicht benachbarte Sauerstoffatome unterbrochen sein kann, besitzt,
R¹⁴⁰, R¹⁵⁰ und R¹⁶⁰ unabhängig voneinander Wasserstoff, C₁-C₁₀-Alkyl, das durch ein oder zwei nicht benachbarte Sauerstoffatome unterbrochen sein kann, C₅-C₇-Cycloalkyl oder Aryl,
R²¹⁰, R²²⁰, R²³⁰ und R²⁴⁰ unabhängig voneinander C₁-C₁₀-Alkyl, das durch ein oder zwei nicht benachbarte Sauerstoffatome unterbrochen sein kann, oder C₅-C₁₀-Cycloalkyl, oder R²¹⁰ und R²²⁰ und/oder R²³⁰ und R²⁴⁰ bilden zusammen mit dem Stickstoffatom, an welches sie gebunden sind, einen fünf- oder sechsgliedrigen Ring, in welchem eine der zum Stickstoffatom nicht benachbarten CH₂-Gruppen durch ein Sauerstoffatom ersetzt sein kann,
R²⁵⁰ und R²⁶⁰ unabhängig voneinander C₁-C₁₀-Alkyl, das durch ein oder zwei nicht benachbarte Sauerstoffatome unterbrochen sein kann, C₅-C₇-Cycloalkyl, Aryl, Aryl-C₁-C₁₀-alkyl oder Aryloxy-C₁-C₁₀-alkyl
und
Z O oder S.

3. Verwendung nach Anspruch 1 oder 2, **dadurch gekennzeichnet, dass** in Komponente K1) die ein oder mehreren Verbindungen der allgemeinen Formel k1 jeweils eine Molekülmasse von maximal 1.000 g/mol, insbesondere maximal 600 g/mol besitzen.

4. Verwendung nach einem oder mehreren der Ansprüche 1 bis 3, **dadurch gekennzeichnet, dass** es sich bei Komponente K2 um ein oder mehrere Fullerene und/oder Fulleren-Derivate handelt.

5. Verwendung nach einem oder mehreren der Ansprüche 1 bis 4, **dadurch gekennzeichnet, dass** es sich bei Komponente K2 um ein oder mehrere C₆₀-Fulleren-Derivate der allgemeinen Formel k2 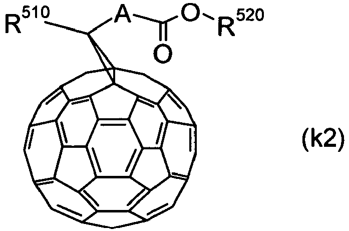 handelt, worin bedeuten
A C₁-C₁₀-Alkylen,
R⁵¹⁰ Aryl oder Aryl-C₁-C₁₀-alkyl
und
R⁵²⁰ C₁-C₁₀-Alkyl.

6. Verwendung nach einem oder mehreren der Ansprüche 1 bis 4, **dadurch gekennzeichnet, dass** die Komponente K1 in einem Anteil von 10 bis 90 Massen-%, insbesondere 20 bis 80 Massen-%, und die Komponente K2 in einem Anteil von 90 bis 10 Massen-%, insbesondere 80 bis 20 Massen-%, vorliegt, wobei sich die Anteile der Komponenten K1 und K2, jeweils bezogen auf die Gesamtmasse der Komponenten K1 und K2, zu 100 Massen-% ergänzen.

7. Mischungen, enthaltend als Komponenten
K1) ein oder mehrere Verbindungen der allgemeinen Formel k1
D-A (k1)
worin bedeuten
D eine Donorgruppierung, ausgewählt aus der Gruppe bestehend aus: 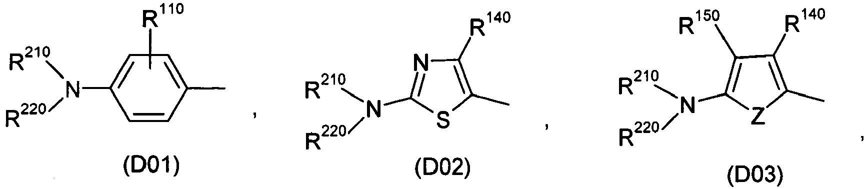 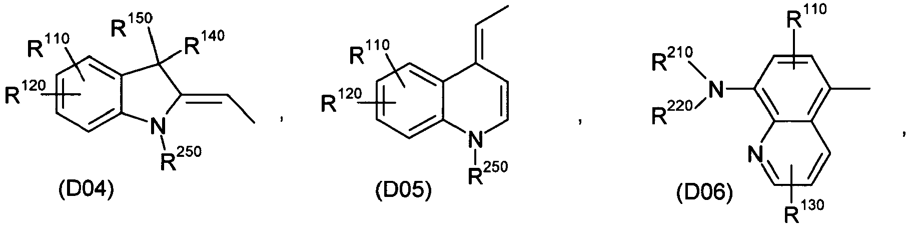 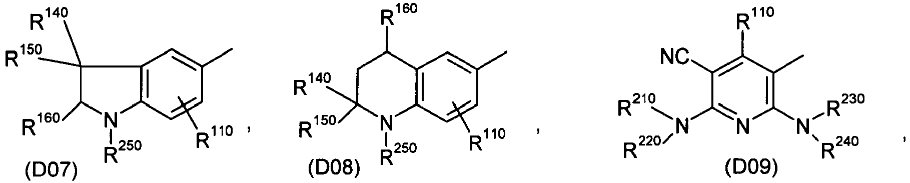 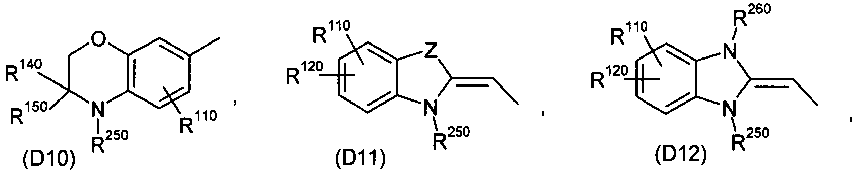 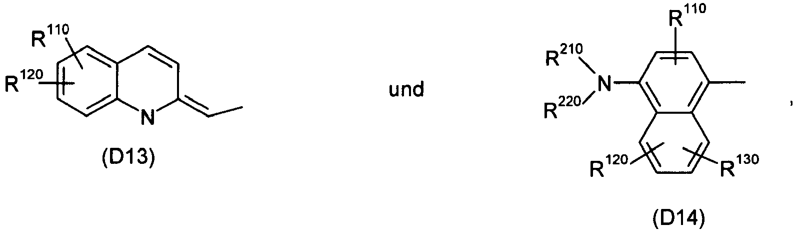 worin bedeuten
R¹¹⁰, R¹²⁰ und R¹³⁰ unabhängig voneinander Wasserstoff, Halogen, Hydroxy, C₁-C₁₀-Alkyl, das durch ein oder zwei nicht benachbarte Sauerstoffatome unterbrochen sein kann, C₅-C₇-Cycloalkyl, C₁-C₁₀-Alkoxy, C₁-C₁₀-Alkylamino, Di(C₁-C₁₀-alkyl)amino, C₁-C₁₀-Alkylamino- oder Di(C₁-C₁₀-alkyl)aminosulfonylamino, C₁-C₁₀-Alkylsulfonylamino, Aryl, Aryl-C₁-C₁₀-alkyl, Aryloxy-C₁-C₁₀-alkyl oder einen Rest-NHCOR¹⁷⁰ oder -NHCOOR¹⁷⁰, worin R¹⁷⁰ die Bedeutung von Aryl, Aryl-C₁-C₁₀-alkyl oder C₁-C₁₀-Alkyl, das durch ein oder zwei nicht benachbarte Sauerstoffatome unterbrochen sein kann, besitzt,
R¹⁴⁰, R¹⁵⁰ und R¹⁶⁰ unabhängig voneinander Wasserstoff, C₁-C₁₀-Alkyl, das durch ein oder zwei nicht benachbarte Sauerstoffatome unterbrochen sein kann, C₅-C₇-Cycloalkyl oder Aryl,
R²¹⁰, R²²⁰, R²³⁰ und R²⁴⁰ unabhängig voneinander C₁-C₁₀-Alkyl, das durch ein oder zwei nicht benachbarte Sauerstoffatome unterbrochen sein kann, oder C₅-C₇-Cycloalkyl, oder R²¹⁰ und R²²⁰ und/oder R²³⁰ und R²⁴⁰ bilden zusammen mit dem Stickstoffatom, an welches sie gebunden sind, einen fünf- oder sechsgliedrigen Ring, in welchem eine der zum Stickstoffatom nicht benachbarten CH₂-Gruppen durch ein Sauerstoffatom ersetzt sein kann,
R²⁵⁰ und R²⁶⁰ unabhängig voneinander C₁-C₁₀-Alkyl, das durch ein oder zwei nicht benachbarte Sauerstoffatome unterbrochen sein kann, C₅-C₇-Cycloalkyl, Aryl, Aryl-C₁-C₁₀-alkyl oder Aryloxy-C₁-C₁₀-alkyl
und
Z O oder S,
A eine Akzeptorgruppierung, ausgewählt aus der Gruppe bestehend aus: 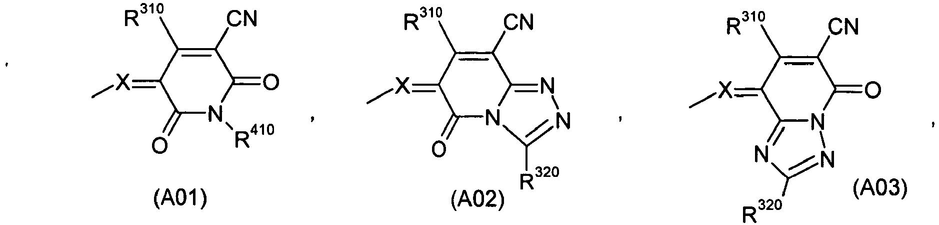 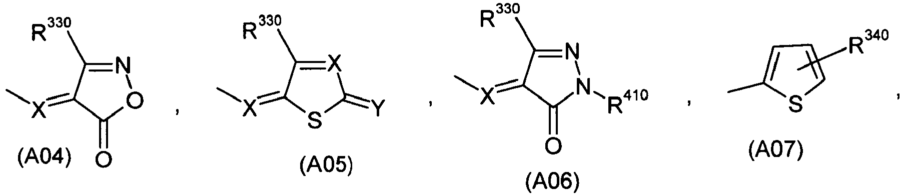 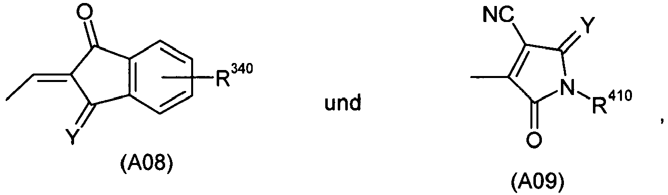
worin bedeuten
R³¹⁰ und R³²⁰ unabhängig voneinander Wasserstoff, C₁-C₁₀-Alkyl, das durch ein oder zwei nicht benachbarte Sauerstoffatome unterbrochen sein kann, oder C₅-C₇-Cycloalkyl,
R³³⁰ Wasserstoff, C₁-C₁₀-Alkyl, das durch ein oder zwei nicht benachbarte Sauerstoffatome unterbrochen sein kann, teilweise fluoriertes C₁-C₁₀-Alkyl, perfluoriertes C₁-C₁₀-Alkyl, C₁-C₇-Cycloalkyl oder Aryl,
R³⁴⁰ Wasserstoff, NO₂, CN, COR³⁵⁰, COOR³⁵⁰, SO₂R³⁵⁰ oder SO₃R³⁵⁰, worin R³⁵⁰ die Bedeutung von Aryl oder C₁-C₁₀-Alkyl besitzt,
R⁴¹⁰ C₁-C₁₀-Alkyl, das durch ein oder zwei nicht benachbarte Sauerstoffatome unterbrochen sein kann, C₅-C₇-Cycloalkyl, Aryl, Aryl-C₁-C₁₀-alkyl, Aryloxy-C₁-C₁₀-Alkyl, einen Rest -NHCOR⁴²⁰ oder einen Rest -N(CO R⁴²⁰)₂, worin R⁴²⁰ die Bedeutung von Aryl, Aryl-C₁-C₁₀-alkyl oder C₁-C₁₀-Alkyl, das durch ein oder zwei nicht benachbarte Sauerstoffatome unterbrochen sein kann, besitzt, und die beiden R⁴²⁰ im Rest -N(CO R⁴²⁰)₂ gleich oder voneinander verschieden sein können,
X unabhängig voneinander CH oder N
und
Y O, C(CN)₂ oder C(CN)(COOR⁴³⁰), worin R⁴³⁰ die Bedeutung C₁-C₁₀-Alkyl, das durch ein oder zwei nicht benachbarte Sauerstoffatome unterbrochen sein kann, besitzt,
und die Donorgruppierung D und die Akzeptorgruppierung A miteinander in π-Konjugation stehen,
und
K2) ein oder mehrere Fullerene und/oder Fulleren-Derivate.

8. Mischung nach Anspruch 7, **dadurch gekennzeichnet, dass** es sich bei Komponente K2 um ein oder mehrere C₆₀-Fulleren-Derivate der allgemeinen Formel k2 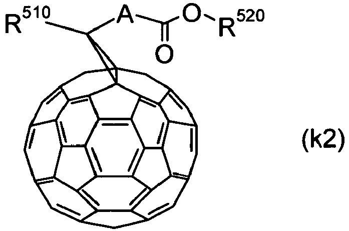 handelt, worin bedeuten
A C₁-C₁₀-Alkylen,
R⁵¹⁰ Aryl oder Aryl-C₁-C₁₀-alkyl
und
R⁵²⁰ C₁-C₁₀-Alkyl.

9. Mischung nach Anspruch 7 oder 8, **dadurch gekennzeichnet, dass** die Komponente K1 in einem Anteil von 10 bis 90 Massen-%, insbesondere 20 bis 80 Massen-%, und die Komponente K2 in einem Anteil von 90 bis 10 Massen-%, insbesondere 80 bis 20 Massen-%, vorliegt, wobei sich die Anteile der Komponenten K1 und K2, jeweils bezogen auf die Gesamtmasse der Komponenten K1 und K2, zu 100 Massen-% ergänzen

10. Organische Solarzellen und organische Photodetektoren, enthaltend photoaktive Schichten, welche Mischungen gemäß Ansprüchen 7-9 enthalten.

## Claims

1. Use of mixtures comprising, as components,
K1) one or more compounds of the general formula k1
D-A (k1)
as an electron donor or electron acceptor, in which
D is a donor moiety which comprises at least one carbon-carbon or carbon-heteroatom double bond and at least one unfused or fused carbo- or heterocyclic ring,
A is an acceptor moiety selected from the group consisting of: 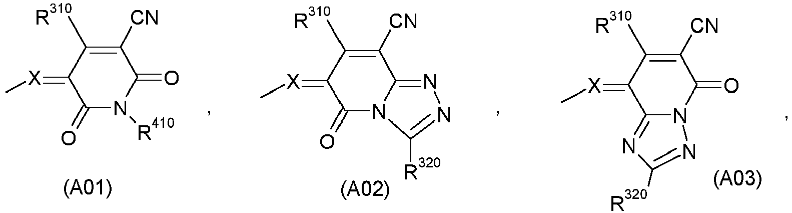 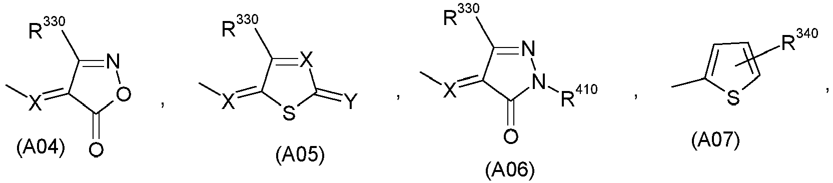 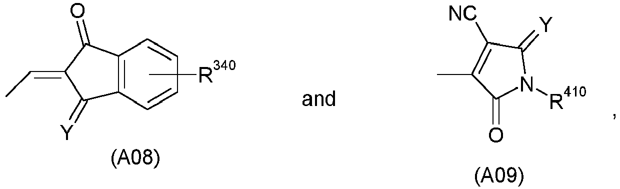
in which
R³¹⁰ and R³²⁰ are each independently hydrogen, C₁-C₁₀-alkyl which may be interrupted by one or two nonadjacent oxygen atoms, or C₅-C₇-cycloalkyl,
R³³⁰ is hydrogen, C₁-C₁₀-alkyl which may be interrupted by one or two nonadjacent oxygen atoms, partly fluorinated C₁-C₁₀-alkyl, perfluorinated C₁-C₁₀-alkyl, C₅-C₇-cycloalkyl or aryl,
R³⁴⁰ is hydrogen, NO₂, CN, COR³⁵⁰, COOR³⁵⁰, SO₂R³⁵⁰ or SO₃R³⁵⁰, in which R³⁵⁰ is defined as aryl or C₁-C₁₀-alkyl,
R⁴¹⁰ is C₁-C₁₀-alkyl which may be interrupted by one or two nonadjacent oxygen atoms, C₅-C₇-cycloalkyl, aryl, aryl-C₁-C₁₀-alkyl, aryloxy-C₁-C₁₀-alkyl, an -NHCOR⁴²⁰ moiety or an -N(CO R⁴²⁰)₂ moiety, in which R⁴²⁰ is defined as aryl, aryl-C₁-C₁₀-alkyl or C₁-C₁₀-alkyl which may be interrupted by one or two nonadjacent oxygen atoms, and the two R⁴²⁰ in the -N(CO R⁴²⁰)₂ moiety may be the same or different,
X is independently CH or N
and
Y is O, C(CN)₂ or C(CN)(COOR⁴³⁰), in which R⁴³⁰ is defined as C₁-C₁₀-alkyl which may be interrupted by one or two nonadjacent oxygen atoms,
and the donor moiety D and the acceptor moiety A are n-conjugated to one another,
and
K2) one or more compounds which act correspondingly as electron acceptors or electron donors toward component K1),
for production of photoactive layers for organic solar cells and organic photodetectors.

2. Use according to Claim 1, **characterized in that** the donor moiety D in the one or more compounds of the general formula k1 is selected from the group consisting of: 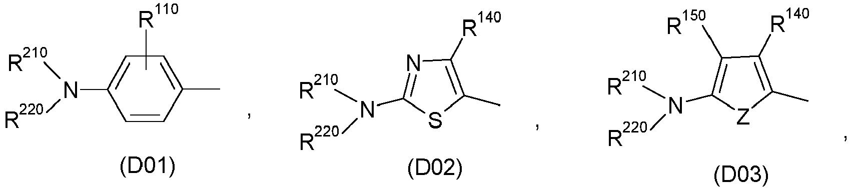 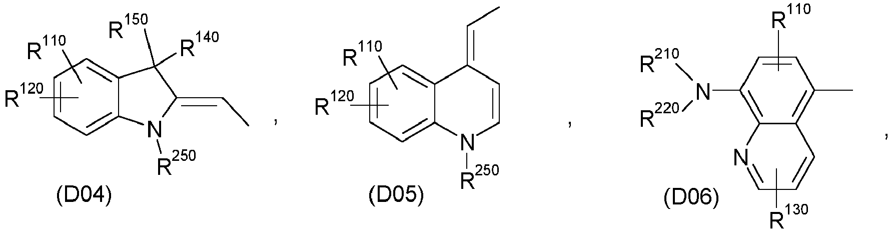 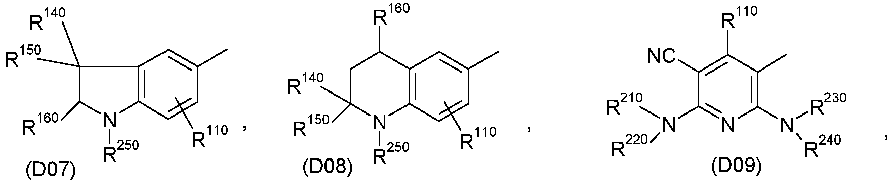 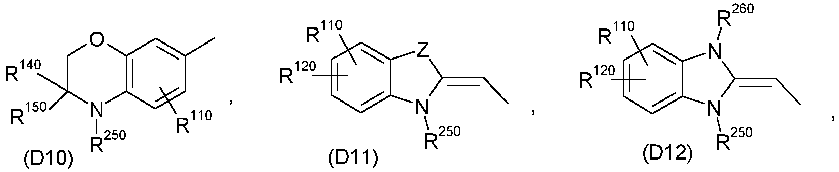 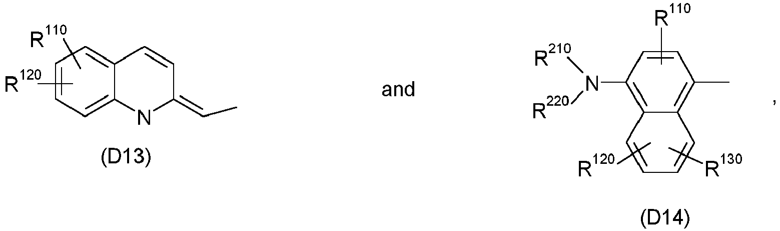 in which
R¹¹⁰, R¹²⁰ and R¹³⁰ are each independently hydrogen, halogen, hydroxyl, C₁-C₁₀-alkyl which may be interrupted by one or two nonadjacent oxygen atoms, C₅-C₇-cycloalkyl, C₁-C₁₀-alkoxy, C₁-C₁₀-alkylamino, di(C₁-C₁₀-alkyl) amino, C₁-C₁₀-alkylamino- or di (C₁-C₁₀-alkyl)aminosulfonylamino, C₁-C₁₀-alkylsulfonylamino, aryl, aryl-C₁-C₁₀-alkyl, aryloxy-C₁-C₁₀-alkyl or an -NHCOR¹⁷⁰ or -NHCOOR¹⁷⁰ moiety, in which R¹⁷⁰ is defined as aryl, aryl-C₁-C₁₀-alkyl or C₁-C₁₀-alkyl which may be interrupted by one or two nonadjacent oxygen atoms,
R¹⁴⁰, R¹⁵⁰ and R¹⁶⁰ are each independently hydrogen, C₁-C₁₀-alkyl which may be interrupted by one or two nonadjacent oxygen atoms, C₅-C₇-cycloalkyl or aryl, R²¹⁰, R²²⁰, R²³⁰ and R²⁴⁰ are each independently C₁-C₁₀-alkyl which may be interrupted by one or two nonadjacent oxygen atoms, or C₅-C₁₀-cycloalkyl, or R²¹⁰ and R²²⁰ and/or R²³⁰ and R²⁴⁰ form, together with the nitrogen atom to which they are bonded, a five- or six-membered ring in which one of the CH₂ groups not adjacent to the nitrogen atom may be replaced by an oxygen atom,
R²⁵⁰ and R²⁶⁰ are each independently C₁-C₁₀-alkyl which may be interrupted by one or two nonadjacent oxygen atoms, C₅-C₇-cycloalkyl, aryl, aryl-C₁-C₁₀-alkyl or aryloxy-C₁-C₁₀-alkyl
and
Z is O or S.

3. Use according to Claim 1 or 2, **characterized in that** the one or more compounds of the general formula k1 in component K1) each have a molecular mass of not more than 1000 g/mol, in particular not more than 600 g/mol.

4. Use according to one or more of Claims 1 to 3, **characterized in that** component K2 is one or more fullerenes and/or fullerene derivatives.

5. Use according to one or more of Claims 1 to 4, **characterized in that** component K2 is one or more C₆₀-fullerene derivatives of the general formula k2 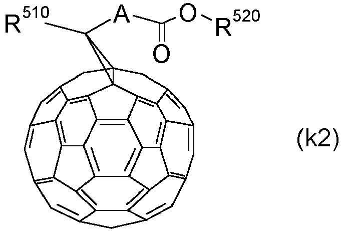 in which
A is C₁-C₁₀-alkylene,
R⁵¹⁰ is aryl or aryl-C₁-C₁₀-alkyl
and
R⁵²⁰ is C₁-C₁₀-alkyl.

6. Use according to one or more of Claims 1 to 4, **characterized in that** component K1 is present in a proportion of 10 to 90% by mass, in particular 20 to 80% by mass, and component K2 in a proportion of 90 to 10% by mass, in particular 80 to 20% by mass, wherein the proportions of components K1 and K2, based in each case on the overall composition of components K1 and K2, add up to 100% by mass.

7. Mixture comprising, as components,
K1) one or more compounds of the general formula k1
D-A (k1)
in which
D is a donor moiety selected from the group consisting of: 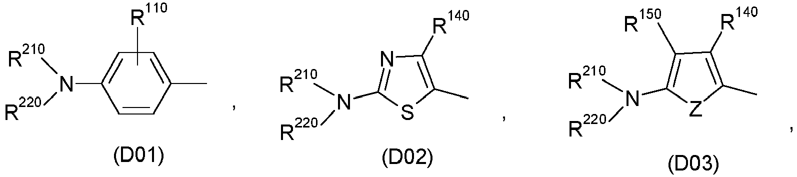 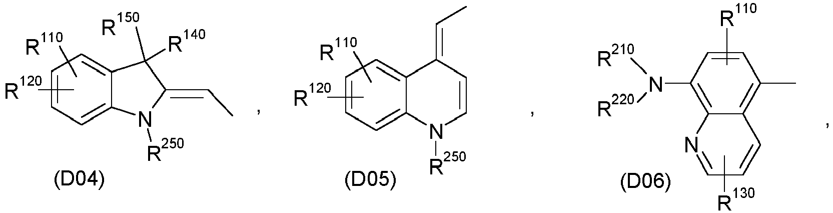 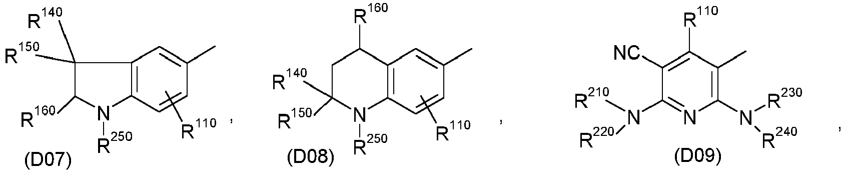 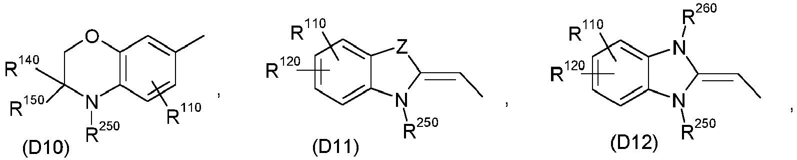 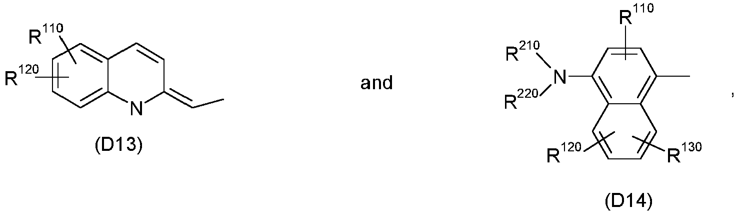 in which
R¹¹⁰, R¹²⁰ and R¹³⁰ are each independently hydrogen, halogen, hydroxyl, C₁-C₁₀-alkyl which may be interrupted by one or two nonadjacent oxygen atoms, C₅-C₇-cycloalkyl, C₁-C₁₀-alkoxy, C₁-C₁₀-alkylamino, di (C₁-C₁₀-alkyl) amino, C₁-C₁₀-alkylamino- or di (C₁-C₁₀-alkyl)aminosulfonylamino, C₁-C₁₀-alkylsulfonylamino, aryl, aryl-C₁-C₁₀-alkyl, aryloxy-C₁-C₁₀-alkyl or an -NHCOR¹⁷⁰ or -NHCOOR¹⁷⁰ moiety, in which R¹⁷⁰ is defined as aryl, aryl-C₁-C₁₀-alkyl or C₁-C₁₀-alkyl which may be interrupted by one or two nonadjacent oxygen atoms,
R¹⁴⁰, R¹⁵⁰ and R¹⁶⁰ are each independently hydrogen, C₁-C₁₀-alkyl which may be interrupted by one or two nonadjacent oxygen atoms, C₅-C₇-cycloalkyl or aryl,
R²¹⁰, R²²⁰, R²³⁰ and R²⁴⁰ are each independently C₁-C₁₀-alkyl which may be interrupted by one or two nonadjacent oxygen atoms, or C₅-C₇-cycloalkyl, or R²¹⁰ and R²²⁰ and/or R²³⁰ and R²⁴⁰ form, together with the nitrogen atom to which they are bonded, a five- or six-membered ring in which one of the CH₂ groups not adjacent to the nitrogen atom may be replaced by an oxygen atom,
R²⁵⁰ and R²⁶⁰ are each independently C₁-C₁₀-alkyl which may be interrupted by one or two nonadjacent oxygen atoms, C₅-C₇-cycloalkyl, aryl, aryl-C₁-C₁₀-alkyl or aryloxy-C₁-C₁₀-alkyl
and
Z is O or S,
A is an acceptor moiety selected from the group consisting of: 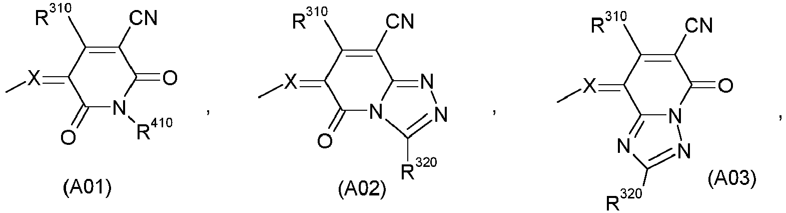 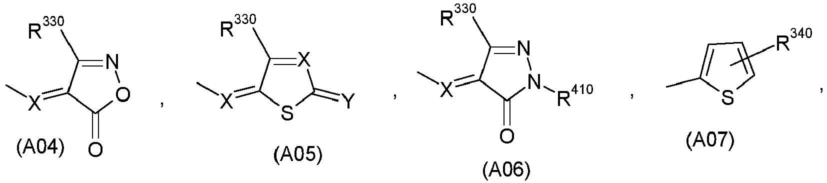 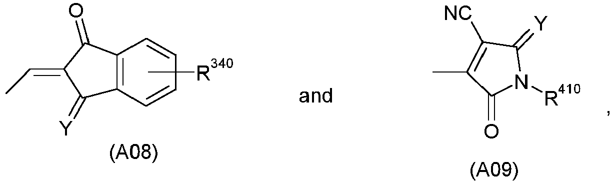 in which
R³¹⁰ and R³²⁰ are each independently hydrogen, C₁-C₁₀-alkyl which may be interrupted by one or two nonadjacent oxygen atoms, or C₅-C₇-cycloalkyl,
R³³⁰ is hydrogen, C₁-C₁₀-alkyl which may be interrupted by one or two nonadjacent oxygen atoms, partly fluorinated C₁-C₁₀-alkyl, perfluorinated C₁-C₁₀-alkyl, C₅-C₇-cycloalkyl or aryl,
R³⁴⁰ is hydrogen, NO₂, CN, COR³⁵⁰, COOR³⁵⁰, SO₂R³⁵⁰ or SO₃R³⁵⁰, in which R³⁵⁰ is defined as aryl or C₁-C₁₀-alkyl, R⁴¹⁰ is C₁-C₁₀-alkyl which may be interrupted by one or two nonadjacent oxygen atoms, C₅-C₇-cycloalkyl, aryl, aryl-C₁-C₁₀-alkyl, aryloxy-C₁-C₁₀-alkyl, an -NHCOR⁴²⁰ moiety or an -N(CO R⁴²⁰)₂ moiety, in which R⁴²⁰ is defined as aryl, aryl-C₁-C₁₀-alkyl or C₁-C₁₀-alkyl which may be interrupted by one or two nonadjacent oxygen atoms, and the two R⁴²⁰ in the -N(CO R⁴²⁰)₂ moiety may be the same or different,
X is independently CH or N
and
Y is O, C(CN)₂ or C(CN) (COOR⁴³⁰), in which R⁴³⁰ is defined as C₁-C₁₀-alkyl which may be interrupted by one or two nonadjacent oxygen atoms,
and the donor moiety D and the acceptor moiety A are n-conjugated to one another,
and
K2) one or more fullerenes and/or fullerene derivatives.

8. Mixture according to Claim 7, **characterized in that** component K2 is one or more C₆₀-fullerene derivatives of the general formula k2 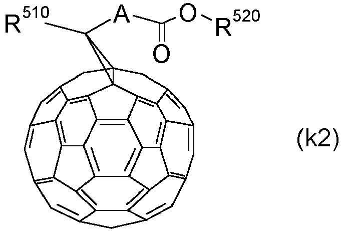 in which
A is C₁-C₁₀-alkylene,
R⁵¹⁰ is aryl or aryl-C₁-C₁₀-alkyl
and
R⁵²⁰ is C₁-C₁₀-alkyl.

9. Mixture according to Claim 7 or 8, **characterized in that** component K1 is present in a proportion of 10 to 90% by mass, in particular 20 to 80% by mass, and component K2 in a proportion of 90 to 10% by mass, in particular 80 to 20% by mass, wherein the proportions of components K1 and K2, based in each case on the overall composition of components K1 and K2, add up to 100% by mass.

10. Organic solar cells and organic photodetectors comprising photoactive layers comprising mixtures according to Claims 7-9.

## Revendications

1. Utilisation de mélanges, contenant en tant que composants
K1) un ou plusieurs composés de formule générale k1
D-A (k1)
en tant que donneur d'électrons ou accepteur d'électrons, formule dans laquelle
D représente un groupement donneur qui contient au moins une double liaison carbone-carbone ou carbone-hétéroatome et au moins un cycle carbocyclique ou hétérocyclique éventuellement condensé,
A représente un groupement accepteur, choisi dans le groupe constitué par : 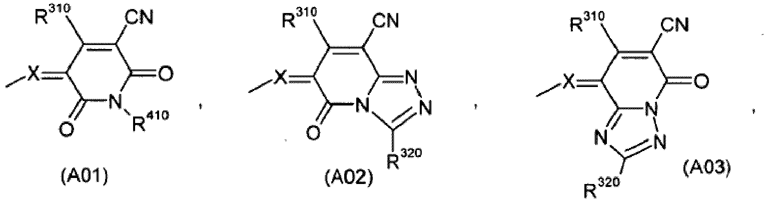 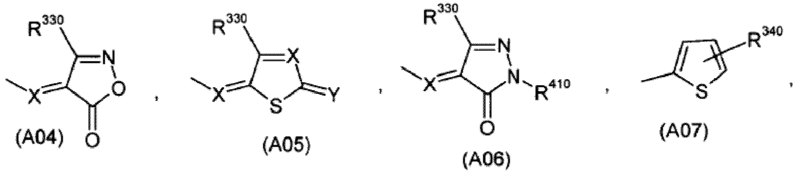 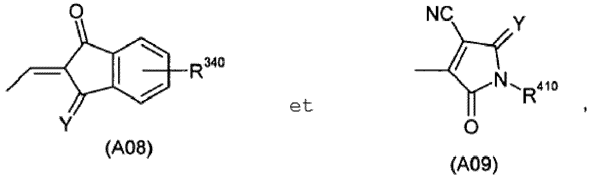
où
R³¹⁰ et R³²⁰ représentent indépendamment l'un de l'autre un atome d'hydrogène, un groupe alkyle en C₁-C₁₀ qui peut être interrompu par un ou deux atomes d'oxygène non contigus, ou un groupe cycloalkyle en C₅-C₇,
R³³⁰ représente un atome d'hydrogène, un groupe alkyle en C₁-C₁₀ qui peut être interrompu par un ou deux atomes d'oxygène non contigus, un groupe alkyle en C₁-C₁₀ partiellement fluoré, un groupe alkyle en C₁-C₁₀ perfluoré, un groupe cycloalkyle en C₅-C₇ ou un groupe aryle,
R³⁴⁰ représente un atome d'hydrogène, un groupe NO₂, CN, COR³⁵⁰, COOR³⁵⁰, SO₂R³⁵⁰ ou SO₃R³⁵⁰, R³⁵⁰ ayant la signification d'un groupe aryle ou alkyle en C₁-C₁₀,
R⁴¹⁰ représente un groupe alkyle en C₁-C₁₀ qui peut être interrompu par un ou deux atomes d'oxygène non contigus, un groupe cycloalkyle en C₅-C₇, aryle, aryl-alkyle (C₁-C₁₀), aryloxy-alkyle (C₁-C₁₀), un radical - NHCOR⁴²⁰ ou un radical -N(COR⁴²⁰)₂, où R⁴²⁰ a la signification d'un groupe aryle, aryl-alkyle(C₁-C₁₀) ou alkyle en C₁-C₁₀ qui peut être interrompu par un ou deux atomes d'oxygène non contigus, et les deux groupes R⁴²⁰ dans le radical -N(COR⁴²⁰)₂ peuvent être identiques ou différents l'un de l'autre,
X représente chaque fois indépendamment CH ou N
et
Y représente O, C(CN)₂ ou C(CN)(COOR⁴³⁰), où R⁴³⁰ a la signification d'un groupe alkyle en C₁-C₁₀ qui peut être interrompu par un ou deux atomes d'oxygène non contigus, et le groupement donneur D et le groupement accepteur A se trouvent l'un avec l'autre en conjugaison de type Π, et
K2) un ou plusieurs composés qui agissent vis-à-vis et en fonction du composant K1) comme accepteur d'électrons ou, respectivement, donneur d'électrons,
pour la production de couches photoactives pour cellules solaires organiques et photodétecteurs organiques.

2. Utilisation selon la revendication 1, **caractérisée en ce que** le groupement donneur D dans lesdits un ou plusieurs composés de formule générale k1 est choisi dans le groupe constitué par : 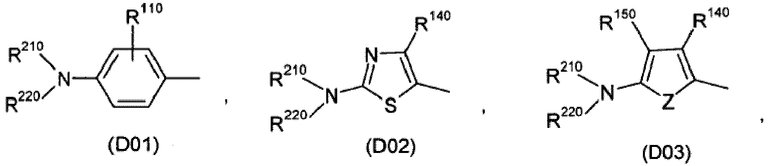 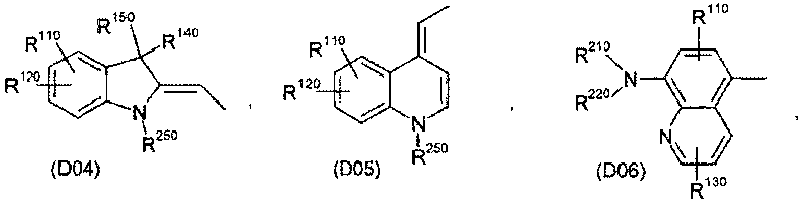 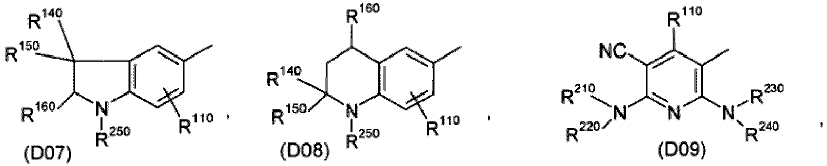 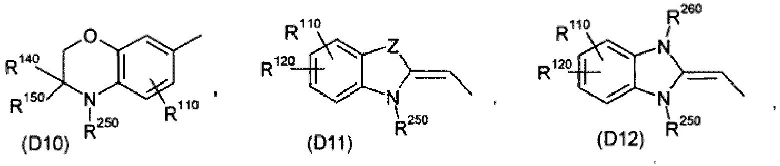 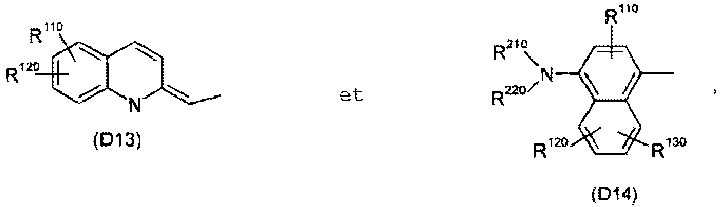 où
R¹¹⁰, R¹²⁰ et R¹³⁰ représentent indépendamment les uns des autres un atome d'hydrogène ou d'halogène, un groupe hydroxy, alkyle en C₁-C₁₀ qui peut être interrompu par un ou deux atomes d'oxygène non contigus, cycloalkyle en C₅-C₇, alcoxy en C₁-C₁₀, alkyl (C₁-C₁₀)-amino, di(alkyl (C₁-C₁₀))amino, alkyl (C₁-C₁₀)amino- ou di(alkyl (C₁-C₁₀)aminosulfonylamino, alkyl (C₁-C₁₀)sulfonylamino, aryle, aryl-alkyle (C₁-C₁₀), aryloxy-alkyle (C₁-C₁₀)ou un radical -NHCOR¹⁷⁰ ou - NHCOOR¹⁷⁰, où R¹⁷⁰ a la signification d'un groupe aryle, aryl-alkyle (C₁-C₁₀) ou alkyle en C₁-C₁₀ qui peut être interrompu par un ou deux atomes d'oxygène non contigus,
R¹⁴⁰, R¹⁵⁰ et R¹⁶⁰ représentent indépendamment les uns des autres un atome d'hydrogène, un groupe alkyle en C₁-C₁₀ qui peut être interrompu par un ou deux atomes d'oxygène non contigus, cycloalkyle en C₅-C₇ ou aryle,
R²¹⁰, R²²⁰, R²³⁰ et R²⁴⁰ représentent indépendamment les uns des autres un groupe alkyle en C₁-C₁₀ qui peut être interrompu par un ou deux atomes d'oxygène non contigus, ou cycloalkyle en C₅-C₁₀, ou R²¹⁰ et R²²⁰ et/ou R²³⁰ et R²⁴⁰ forment ensemble avec l'atome d'azote, auquel ils sont liés, un cycle à cinq ou six chaînons, dans lequel un des groupes CH₂ non contigus à l'atome d'azote peut être remplacé par un atome d'oxygène,
R²⁵⁰ et R²⁶⁰ représentent indépendamment l'un de l'autre un groupe alkyle en C₁-C₁₀ qui peut être interrompu par un ou deux atomes d'oxygène non contigus, cycloalkyle en C₅-C₇, aryle, aryl-alkyle(C₁-C₁₀) ou aryloxy-alkyle (C₁-C₁₀)
et
Z représente un atome d'oxygène ou de soufre.

3. Utilisation selon la revendication 1 ou 2, **caractérisée en ce que** dans le composant K1) lesdits un ou plusieurs composés de formule générale k1 ont chacun une masse moléculaire d'au maximum 1 000 g/mole, en particulier d'au maximum 600 g/mole.

4. Utilisation selon une ou plusieurs des revendications 1 à 3, **caractérisée en ce que** pour ce qui est du composant K2 il s'agit d'un ou de plusieurs fullerènes et/ou dérivés de fullerène.

5. Utilisation selon une ou plusieurs des revendications 1 à 4, **caractérisée en ce que** pour ce qui est du composant K2 il s'agit d'un ou de plusieurs dérivés de fullerène de formule générale k2 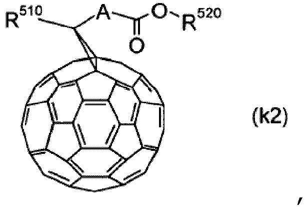 dans laquelle
A représente un groupe alkylène en C₁-C₁₀,
R⁵¹⁰ représente un groupe aryle ou aryl-alkyle(C₁-C₁₀) et
R⁵²⁰ représente un groupe alkyle en C₁-C₁₀.

6. Utilisation selon une ou plusieurs des revendications 1 à 4, **caractérisée en ce que** le composant K1 est présent en une proportion de 10 à 90 % en masse, en particulier 20 à 80 % en masse, et le composant K2 est présent en une proportion de 90 à 10 % en masse, en particulier 80 à 20 % en masse, les proportions des composants K1 et K2 se complétant à 100 % en masse, chaque fois par rapport à la masse totale des composants K1 et K2.

7. Mélanges, contenant en tant que composants
K1) un ou plusieurs composés de formule générale k1
D-A (k1)
dans laquelle
D représente un groupement donneur, choisi dans le groupe constitué par : 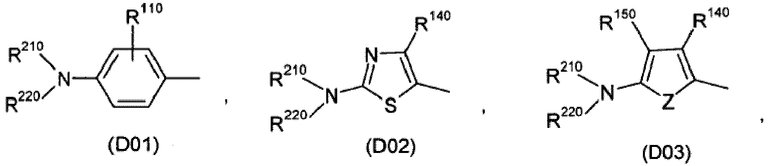 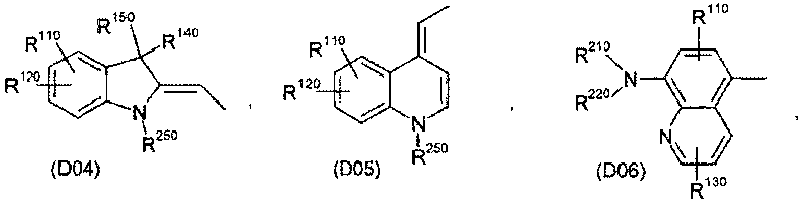 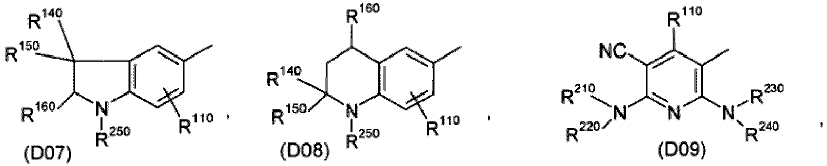 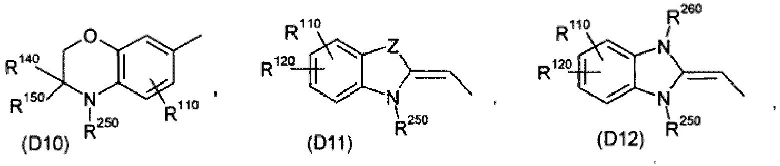 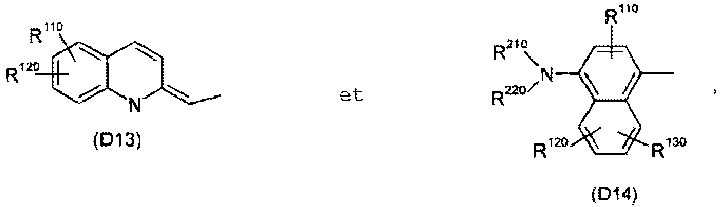 où
R¹¹⁰, R¹²⁰ et R¹³⁰ représentent indépendamment les uns des autres un atome d'hydrogène ou d'halogène, un groupe hydroxy, alkyle en C₁-C₁₀ qui peut être interrompu par un ou deux atomes d'oxygène non contigus, cycloalkyle en C₅-C₇, alcoxy en C₁-C₁₀, alkyl (C₁-C₁₀)-amino, di(alkyl (C₁-C₁₀))amino, alkyl (C₁-C₁₀)amino- ou di(alkyl (C₁-C₁₀)aminosulfonylamino,
alkyl (C₁-C₁₀)sulfonylamino, aryle, aryl-alkyle (C₁-C₁₀), aryloxy-alkyle (C₁-C₁₀)ou un radical -NHCOR¹⁷⁰ ou - NHCOOR¹⁷⁰, où R¹⁷⁰ a la signification d'un groupe aryle, aryl-alkyle (C₁-C₁₀) ou alkyle en C₁-C₁₀ qui peut être interrompu par un ou deux atomes d'oxygène non contigus, R¹⁴⁰, R¹⁵⁰ et R¹⁶⁰ représentent indépendamment les uns des autres un atome d'hydrogène, un groupe alkyle en C₁-C₁₀ qui peut être interrompu par un ou deux atomes d'oxygène non contigus, cycloalkyle en C₅-C₇ ou aryle,
R²¹⁰, R²²⁰, R²³⁰ et R²⁴⁰ représentent indépendamment les uns des autres un groupe alkyle en C₁-C₁₀ qui peut être interrompu par un ou deux atomes d'oxygène non contigus, ou cycloalkyle en C₅-C₇, ou R²¹⁰ et R²²⁰ et/ou R²³⁰ et R²⁴⁰ forment ensemble avec l'atome d'azote, auquel ils sont liés, un cycle à cinq ou six chaînons, dans lequel un des groupes CH₂ non contigus à l'atome d'azote peut être remplacé par un atome d'oxygène,
R²⁵⁰ et R²⁶⁰ représentent indépendamment les uns des autres un groupe alkyle en C₁-C₁₀ qui peut être interrompu par un ou deux atomes d'oxygène non contigus, cycloalkyle en C₅-C₇, aryle, aryl-alkyle(C₁-C₁₀) ou aryloxy-alkyle (C₁-C₁₀)
et
Z représente un atome d'oxygène ou de soufre.
A représente un groupement accepteur, choisi dans le groupe constitué par : 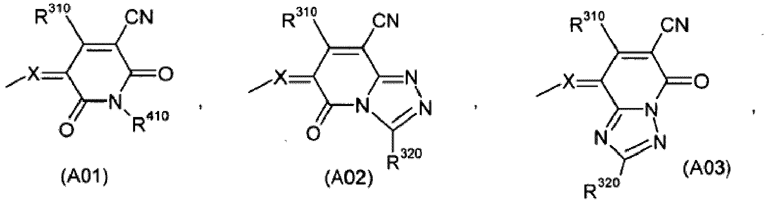 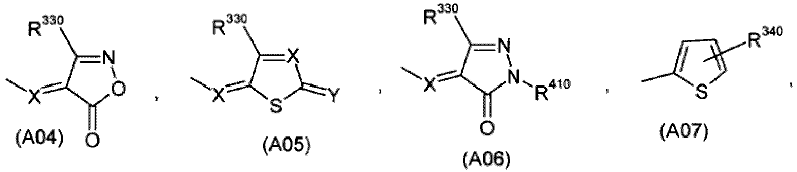 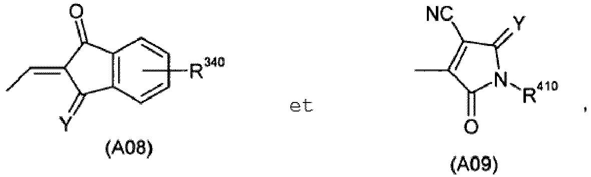 où
R³¹⁰ et R³²⁰ représentent indépendamment l'un de l'autre un atome d'hydrogène, un groupe alkyle en C₁-C₁₀ qui peut être interrompu par un ou deux atomes d'oxygène non contigus, ou un groupe cycloalkyle en C₅-C₇,
R³³⁰ représente un atome d'hydrogène, un groupe alkyle en C₁-C₁₀ qui peut être interrompu par un ou deux atomes d'oxygène non contigus, un groupe alkyle en C₁-C₁₀ partiellement fluoré, un groupe alkyle en C₁-C₁₀ perfluoré, un groupe cycloalkyle en C₅-C₇ ou un groupe aryle,
R³⁴⁰ représente un atome d'hydrogène, un groupe NO₂, CN, COR³⁵⁰, COOR³⁵⁰, SO₂R³⁵⁰ ou SO₃R³⁵⁰, R³⁵⁰ ayant la signification d'un groupe aryle ou alkyle en C₁-C₁₀,
R⁴¹⁰ représente un groupe alkyle en C₁-C₁₀ qui peut être interrompu par un ou deux atomes d'oxygène non contigus, un groupe cycloalkyle en C₅-C₇, aryle, aryl-alkyle (C₁-C₁₀), aryloxy-alkyle (C₁-C₁₀), un radical - NHCOR⁴²⁰ ou un radical -N(COR⁴²⁰)₂, où R⁴²⁰ a la signification d'un groupe aryle, aryl-alkyle(C₁-C₁₀) ou alkyle en C₁-C₁₀ qui peut être interrompu par un ou deux atomes d'oxygène non contigus, et les deux groupes R⁴²⁰ dans le radical -N(COR⁴²⁰)₂ peuvent être identiques ou différents l'un de l'autre,
X représente chaque fois indépendamment CH ou N
et
Y représente O, C(CN)₂ ou C(CN)(COOR⁴³⁰), où R⁴³⁰ a la signification d'un groupe alkyle en C₁-C₁₀ qui peut être interrompu par un ou deux atomes d'oxygène non contigus, et le groupement donneur D et le groupement accepteur A se trouvent l'un avec l'autre en conjugaison de type Π, et
K2) un ou plusieurs fullerènes et/ou dérivés de fullerène.

8. Mélange selon la revendication 7, **caractérisé en ce que** pour ce qui est du composant K2 il s'agit d'un ou de plusieurs dérivés de fullerène de formule générale k2 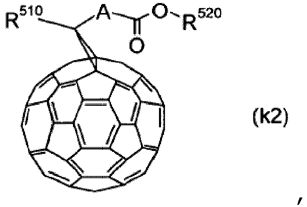 dans laquelle
A représente un groupe alkylène en C₁-C₁₀,
R⁵¹⁰ représente un groupe aryle ou aryl-alkyle(C₁-C₁₀) et
R⁵²⁰ représente un groupe alkyle en C₁-C₁₀.

9. Mélange selon la revendication 7 ou 8, **caractérisé en ce que** le composant K1 est présent en une proportion de 10 à 90 % en masse, en particulier 20 à 80 % en masse, et le composant K2 est présent en une proportion de 90 à 10 % en masse, en particulier 80 à 20 % en masse, les proportions des composants K1 et K2 se complétant à 100 % en masse, chaque fois par rapport à la masse totale des composants K1 et K2.

10. Cellules solaires organiques et photodétecteurs organiques, contenant des couches photoactives qui contiennent des mélanges selon les revendications 7-9.
